# EUROPEAN PATENT APPLICATION

(11) **EP 4 647 621 A1**
(43) Date of publication of application: **12.11.2025**
(21) Application number: 24818519.1
(22) Date of filing: 25.05.2024
(51) Int. Cl.: F16C 11/10, F16C 11/04, F16C 11/00, E05D 11/08, E05D 11/00, H05K 5/02, F16M 13/00

(54) **ROTATING SHAFT DEVICE, ELECTRONIC APPARATUS AND HOUSING**

(30) Priority: 07.06.2023 CN 202310672010; 20.06.2023 CN 202310735074
(71) Applicant: Huawei Technologies Co., Ltd., Shenzhen, Guangdong 518129 (CN)
(72) Inventor: PENG, Lexiong, Shenzhen, Guangdong 518129 (CN); WEI, Qinan, Shenzhen, Guangdong 518129 (CN); ZHANG, Jiayao, Shenzhen, Guangdong 518129 (CN); ZHAO, Jie, Shenzhen, Guangdong 518129 (CN); TU, Yiming, Shenzhen, Guangdong 518129 (CN); RAO, Yingchun, Shenzhen, Guangdong 518129 (CN); HU, Lina, Shenzhen, Guangdong 518129 (CN)
(74) Representative: Goddar, Heinz J.
(86) International application number: PCT/CN2024/095362
(87) International publication number: WO 2024/250986

(57) **Abstract**

A hinge apparatus (10), an electronic device (1), and a housing (21) are provided. The hinge apparatus (10) includes a base (500), a bearing bracket (400), a first shaft core (200), a second shaft core (300), and a first shaft sleeve assembly (100). The first shaft core (200) is fastened to the bearing bracket (400). The second shaft core (300) is slidably connected to the base (500). A first end of the first shaft sleeve assembly (100) is sleeved on the first shaft core (200) and is capable of rotating relative to the first shaft core (200), a second end of the first shaft sleeve assembly (100) is sleeved on the second shaft core (300) and is capable of rotating relative to the second shaft core (300), and the two ends of the first shaft sleeve assembly (100) are respectively in interference fit with the first shaft core (200) and the second shaft core (300), to enable the first shaft sleeve assembly (100) and each of the first shaft core (200) and the second shaft core (300) to be configured to provide a torque for the hinge apparatus (10) in a process in which the hinge apparatus (10) switches between an open state and a closed state. The hinge apparatus (10) can provide a large torque, to resolve a problem of support stability of the electronic device (1) and meet a requirement for large-angle support.

## Description

This application claims priorities to Chinese Patent Application No. 202310672010.9, filed with the China National Intellectual Property Administration on June 7, 2023 and entitled "HINGE APPARATUS AND ELECTRONIC DEVICE", and to Chinese Patent Application No. 202310735074.9, filed with the China National Intellectual Property Administration on June 20, 2023 and entitled "HINGE APPARATUS, ELECTRONIC DEVICE, AND HOUSING", both of which are incorporated herein by reference in their entireties.

### TECHNICAL FIELD

This application relates to the field of electronic devices, and in particular, to a hinge apparatus, an electronic device, and a housing.

### BACKGROUND

Mobile electronic devices are available everywhere in various office and life scenarios. With continuous development of electronic devices, users have increasingly diversified requirements for using the electronic devices. To improve user experience, a flippable hinge apparatus is mounted on the electronic device, so that the hinge apparatus can support the electronic device at a specific angle. This helps meet use requirements of the users in different scenarios.

When the hinge apparatus supports the electronic device, a torque is required to generate damping, so that the hinge apparatus is not prone to toppling due to a weight of the electronic device. However, the current hinge apparatus can provide a small torque, and it is difficult to meet a requirement for large-angle support. Consequently, it is difficult to stably maintain the electronic device at a specific angle in a process of supporting the electronic device.

### SUMMARY

This application provides a hinge apparatus, an electronic device, and a housing.

According to a first aspect, an embodiment of this application provides a hinge apparatus having an open state and a closed state. The hinge apparatus includes a base, a bearing bracket, a first shaft core, a second shaft core, and a first shaft sleeve assembly. The bearing bracket is rotatably connected to the base, for the bearing bracket to be opened or closed relative to the base. The first shaft core is fastened to the bearing bracket. The second shaft core is slidably connected to the base. A first end of the first shaft sleeve assembly is sleeved on the first shaft core and is capable of rotating relative to the first shaft core, a second end of the first shaft sleeve assembly is sleeved on the second shaft core and is capable of rotating relative to the second shaft core, and the two ends of the first shaft sleeve assembly are respectively in interference fit with the first shaft core and the second shaft core, to enable the first shaft sleeve assembly and each of the first shaft core and the second shaft core to be configured to provide a torque for the hinge apparatus in a process in which the hinge apparatus switches between the open state and the closed state.

In this implementation, opening and closing of the bearing bracket relative to the base correspond to the open state and the closed state of the hinge apparatus. The hinge apparatus is fastened to the support member via the bearing bracket. A user exerts an acting force on the support member, for the bearing bracket to rotate relative to the base. Further, the hinge apparatus switches between the open state and the closed state.

In this implementation, the first shaft sleeve assembly can rotate relative to the bearing bracket and the base. The two ends of the first shaft sleeve assembly are of a hollow structure, the first shaft core and the second shaft core are respectively configured to support the two ends of the first shaft sleeve assembly, and inner walls of the two ends of the first shaft sleeve assembly are respectively in interference fit with outer walls of the first shaft core and the second shaft core. The interference fit is interference fit or a fit manner in which a torque and a friction force can be generated. When the first end of the first shaft sleeve assembly is in interference fit with the first shaft core, the first end of the first shaft sleeve assembly and the first shaft core can still rotate relative to each other. However, when the first end of the first shaft sleeve assembly rotates relative to the first shaft core, an acting force needs to be exerted on the bearing bracket, and the first end of the first shaft sleeve assembly is in interference fit with the first shaft core to provide a torque, so that a required opening/closing angle can be maintained between the first end of the first shaft sleeve assembly and the first shaft core when the first end of the first shaft sleeve assembly and the first shaft core rotate relative to each other. A similar principle applies to the second end of the first shaft sleeve assembly and the second shaft core.

In this application, in comparison with that the torque is provided only at the first shaft core, torques can be provided at two locations in the hinge apparatus in this application, and the torques are provided through interference fit at locations at which the two ends of the first shaft sleeve assembly are connected to the first shaft core and the second shaft core, so that an overall torque is increased. In one aspect, because the overall torque is increased, resistance to the user is increased when the user pushes the support member. In this way, the user can more precisely control an opening/closing angle, to meet use requirements of the user in different scenarios. In another aspect, after the user determines the opening/closing angle of an electronic device, because the hinge apparatus has a large torque, the opening/closing angle of the electronic device is not prone to changing, in other words, the hinge apparatus can stably support the electronic device, and is not prone to toppling even at a large opening/closing angle. This helps prevent the electronic device from being damaged.

In an implementation, a rotation center at which the bearing bracket rotates around the base is denoted as a virtual central axis, and the first shaft core and the second shaft core are parallel to the virtual central axis. In a first direction, the first shaft core is located between the second shaft core and the virtual central axis, and the first direction is perpendicular to the virtual central axis and parallel to a surface that is of the base and that faces the bearing bracket.

In this implementation, this solution provides a layout manner of the first shaft core, the second shaft core, and the virtual central axis, and torques can be provided at two locations in the hinge apparatus. This helps enhance stability of the hinge apparatus when the hinge apparatus supports the electronic device.

In an implementation, the second shaft core is located between the first shaft core and the virtual central axis. This solution provides a layout manner of the first shaft core, the second shaft core, and the virtual central axis, and torques can be provided at two locations in the hinge apparatus. This helps enhance stability of the hinge apparatus when the hinge apparatus supports the electronic device.

In an implementation, in the first direction, the virtual central axis is located between the first shaft core and the second shaft core. This solution provides a layout manner of the first shaft core, the second shaft core, and the virtual central axis, and torques can be provided at two locations in the hinge apparatus. This helps enhance stability of the hinge apparatus when the hinge apparatus supports the electronic device.

In an implementation, the first shaft core coincides with the virtual central axis in the first direction, and the second shaft core and the virtual central axis are spaced apart in the first direction. This solution provides a layout manner of the first shaft core, the second shaft core, and the virtual central axis, and torques can be provided at two locations in the hinge apparatus. This helps enhance stability of the hinge apparatus when the hinge apparatus supports the electronic device.

In an implementation, the first shaft sleeve assembly includes a first shaft sleeve and a second shaft sleeve that are fastened to each other, the first shaft sleeve is sleeved on the first shaft core, is capable of rotating relative to the first shaft core, and is in interference fit with the first shaft core, and the second shaft sleeve is sleeved on the second shaft core, is capable of rotating relative to the second shaft core, and is in interference fit with the second shaft core. In this implementation, the first shaft sleeve is fastened to the second shaft sleeve. During opening and closing of the hinge apparatus, the first shaft sleeve and the second shaft sleeve can keep moving or stationary synchronously. This helps ensure smooth movement of the first shaft sleeve assembly, and further improve stability of the hinge apparatus when the hinge apparatus supports the electronic device. The first shaft sleeve is in interference fit with the first shaft core, so that a torque can be generated in a process in which the first shaft sleeve rotates relative to the first shaft core. A similar principle applies to the second shaft sleeve and the second shaft core. The first shaft sleeve and the second shaft sleeve each can provide a torque in the hinge apparatus. This helps increase a total torque provided by the hinge apparatus during opening and closing, so that the hinge apparatus can stably support the electronic device at an angle set by the user.

In an implementation, the first shaft sleeve assembly further includes a first connecting rod, the first connecting rod is connected between the first shaft sleeve and the second shaft sleeve, and an extension direction of the first connecting rod is perpendicular to an axial direction of the first shaft sleeve. In this implementation, the first shaft sleeve is fastened to the second shaft sleeve via the first connecting rod, and the first connecting rod is configured to transmit power from the first shaft sleeve to the second shaft sleeve, so that the first shaft sleeve assembly rotates as a whole. In an implementation, the first shaft sleeve, the first connecting rod, and the second shaft sleeve are integrally formed. According to this implementation, stability of an overall structure of the first shaft sleeve assembly can be improved.

In an implementation, the bearing bracket includes an avoidance hole, the avoidance hole penetrates the bearing bracket, and a part of the first shaft sleeve is located in the avoidance hole. According to this solution, a volume of the hinge apparatus can be reduced, to help implement a miniaturization design.

In an implementation, the bearing bracket further includes first shaft core mounting holes. The first shaft core mounting holes are located at two ends of the bearing bracket in a second direction. The first shaft core includes a first end and a second end that are disposed opposite to each other. Both the first end and the second end of the first shaft core are in flat fit with the first shaft core mounting holes to keep relative fastening. In this implementation, the second direction is a width direction of the hinge apparatus. A part between the first end of the first shaft core and the second end of the first shaft core is in interference fit with the first shaft sleeve, and the first end and the second end of the first shaft core are in flat fit with the first shaft core mounting holes to keep relative fastening.

The first end of the first shaft core is used as an example. Flat fit means that flat locations are respectively provided on an outer wall of the first end of the first shaft core and an inner wall of the first shaft core mounting hole and are opposite to each other. The flat locations are in contact with each other, so that no relative movement occurs between the first end of the first shaft core and the first shaft core mounting hole. Specifically, the first shaft core mounting hole is in a racetrack shape and has two oppositely disposed planes on an inner surface, and there are two oppositely disposed planes on outer circumferential surfaces of the first end and the second end of the first shaft core. When the first end and the second end of the first shaft core are located in the first shaft core mounting holes, planes of the outer circumferential surfaces of the first end and the second end are attached to planes of inner surfaces of the first shaft core mounting holes, so that both the first end and the second end of the first shaft core are in flat fit with the first shaft core mounting holes.

In an implementation, the first shaft sleeve is provided with a first opening that penetrates an inner surface and an outer surface of the first shaft sleeve, and the first opening extends in an axial direction of the first shaft sleeve. In this implementation, the first shaft sleeve is not in a closed cylindrical shape. Because the first shaft sleeve is in interference fit with the first shaft core, the first shaft sleeve is subject to specific resistance when rotating relative to the first shaft core. In this solution, the first opening is disposed in the first shaft sleeve, so that a rotation amplitude of the first shaft sleeve relative to the first shaft core can be increased. In addition, the first opening can be further used to increase elasticity of the first shaft sleeve.

In an implementation, the second shaft sleeve is provided with a second opening that penetrates an inner surface and an outer surface of the second shaft sleeve, and the second opening extends in an axial direction of the second shaft sleeve. When the first shaft sleeve is provided with the first opening and the second shaft sleeve is provided with the second opening, the first opening and the second opening may be opened in different directions. In this implementation, the second shaft sleeve is not in a closed cylindrical shape. Because the second shaft sleeve is in interference fit with the second shaft core, the second shaft sleeve is subject to specific resistance when rotating relative to the second shaft core. In this solution, the second opening is disposed in the second shaft sleeve, so that a rotation amplitude of the second shaft sleeve relative to the second shaft core can be increased.

In an implementation, a first shaft sleeve plane part is provided on the inner surface of the first shaft sleeve, a first shaft core plane part parallel to the shaft sleeve plane part is provided on an outer surface of the first shaft core, and in the closed state, the first shaft sleeve plane part and the first shaft core plane part are disposed opposite to each other. In this implementation, the first shaft sleeve plane part fits the first shaft core plane part, and in the closed state, both the first shaft sleeve plane part and the first shaft core plane part are parallel to a bottom of the base. When the hinge apparatus is in the closed state, the first shaft sleeve and the first shaft core need to be kept from rotating relative to each other. Therefore, in this solution, the first shaft sleeve plane part and the first shaft core plane part are disposed, so that the first shaft sleeve and the first shaft core can be limited in a circumferential direction. Further, the hinge apparatus is locked in the closed state.

In an implementation, the first shaft sleeve plane part is provided on the inner surface of the first shaft sleeve, an open-lock plane part is further provided on the outer surface of the first shaft core, in the closed state, the first shaft sleeve plane part is spaced from the open-lock plane part, and in the open state, the first shaft sleeve plane part and the open-lock plane part are disposed opposite to each other. In this implementation, in a process in which the hinge apparatus switches from the closed state to the open state, when the first shaft sleeve plane part rotates to be disposed opposite to and parallel to the open-lock plane part, the hinge apparatus is locked and maintained at an opening angle, so that the hinge apparatus can be stably maintained in the open state.

In an implementation, in the closed state, there is an included angle between the first shaft sleeve plane part and the first shaft core plane part. In a process in which the hinge apparatus switches from the closed state to the open state, when the first shaft sleeve plane part rotates to be parallel to the first shaft core plane part, the hinge apparatus is locked and maintained at the opening angle, so that the hinge apparatus can be stably maintained in the open state. According to this solution, the hinge apparatus can be locked at a specific angle in a process of opening the hinge apparatus, so that the hinge apparatus can meet use requirements in different scenarios.

In an implementation, the first shaft sleeve, the first connecting rod, and the second shaft sleeve are sheet metal parts or metal injection molded parts. In this implementation, a sheet metal machining technique enables machining procedures of the first shaft sleeve, the first connecting rod, and the second shaft sleeve to be simple, and facilitates large-scale production. A metal injection molding technology has advantages such as high efficiency, low costs, and high precision. The first shaft sleeve, the first connecting rod, and the second shaft sleeve can be quickly and accurately manufactured by using the metal injection molding technology.

In an implementation, the second shaft core is in interference fit with the base, so that a torque is generated in a process in which the second shaft core and the base slide relative to each other. In this implementation, in a sliding process of the second shaft core, a friction force between the second shaft core and the base can be used to increase a total torque provided by the hinge apparatus. This helps ensure that the hinge apparatus is stably maintained at a specific angle.

In an implementation, the second shaft core slides relative to the base in the first direction, and the first direction intersects an axis of the second shaft core. In this implementation, the first direction is a length direction of the hinge apparatus, and the second shaft core slides in the first direction. This can effectively use a size of the hinge apparatus in the length direction, thereby helping reduce a volume of the hinge apparatus.

In an implementation, a direction in which the second shaft core slides relative to the base has a component in the first direction and the second shaft core slides in a straight line. In this implementation, the direction in which the second shaft core can slide relative to the base intersects the first direction, to increase a sliding distance, and further improve a sliding torque. This can effectively use the size of the hinge apparatus in the length direction, thereby helping reduce the volume of the hinge apparatus.

In an implementation, the second shaft core slides relative to the base in an arc direction, where the arc direction has a component in the first direction. In this implementation, the second shaft core can slide relative to the base in the arc direction, and a sliding distance in the arc direction can be increased compared with that in the first direction, to increase a sliding torque. This can effectively use the size of the hinge apparatus in the length direction, thereby helping reduce the volume of the hinge apparatus.

In an implementation, the hinge apparatus further includes two sliding blocks, the two sliding blocks are respectively fastened to two ends of the second shaft core in a second direction, the base includes two support plates that are arranged in the second direction and are spaced apart, and the two sliding blocks and the second shaft core are located between the two support plates in the second direction. The sliding block and the support plate that are disposed on a same side in the second direction are slidably connected and can slide relative to each other, and the second direction is parallel to an axis of the second shaft core. In this implementation, two opposite ends of the two sliding blocks in the second direction are fastened to the two ends of the second shaft core in the second direction, and two ends of the two sliding blocks that are back to each other in the second direction can be respectively slidably connected to the two support plates, so that the two sliding blocks and the second shaft core can slide relative to the two support plates. In this implementation, the second shaft core is further in interference fit with the second shaft sleeve, and the second shaft sleeve may transmit power to the second shaft core, to drive the second shaft core to slide relative to the base.

In an implementation, in the sliding block and the support plate that are disposed on the same side in the second direction, a protrusion is provided on a side that is of the support plate and that faces the sliding block in the second direction, a groove is provided on a side that is of the sliding block and that faces the support plate, and the protrusion is located in the groove and is capable of sliding relative to the groove. In this implementation, a protruding direction of the protrusion is the same as a concave direction of a first groove, a shape of the protrusion fits a shape of the first groove, and the sliding block and the support plate fit each other via the first groove and the protrusion, so that the sliding block and the support plate are slidably connected. According to this solution, a sliding connection is implemented through concave-convex fit, and a structure is simple and easy to machine.

In an implementation, extension directions of the protrusion and the first groove are parallel to the first direction, so that the second shaft core slides relative to the base in the first direction. This can effectively use the size of the hinge apparatus in the length direction, thereby helping reduce the volume of the hinge apparatus.

In an implementation, the protrusion is in interference fit with a groove wall of the first groove. In this implementation, that the protrusion is in interference fit with the first groove means that the protrusion and the first groove are subject to specific friction resistance when sliding relative to each other. This can increase a torque, thereby improving stability of the hinge apparatus. In this implementation, the second shaft core and the base are in indirect contact and in interference fit with each other through the interference fit between the protrusion and the groove wall of the first groove.

In an implementation, the base includes two support plates that are spaced apart in the second direction, the two support plates each are provided with a base sliding groove, two ends of the second shaft core in the second direction penetrate the base sliding grooves, and the base sliding grooves extend in the first direction. The second shaft core slides in the base sliding grooves in the first direction, so that the first shaft sleeve assembly slides relative to the base in the first direction.

In this implementation, the base sliding grooves penetrate two end faces of the support plates in the second direction, and the base sliding grooves extend in the first direction, so that one end of the second shaft core located in the base sliding grooves can slide in the first direction. Because the first direction is the length direction of the hinge apparatus, the size of the hinge apparatus in the length direction can be effectively used by disposing the second shaft core to slide in the first direction. The second shaft core is in interference fit with the other end of the first shaft sleeve assembly, and the second shaft core can slide relative to the base in the first direction, so that the first shaft sleeve assembly can slide in the first direction.

In an implementation, the second shaft core is in interference fit with inner walls of the base sliding grooves. In this implementation, a friction force between the second shaft core and the base sliding grooves can be used to increase a total torque provided by the hinge apparatus, thereby improving stability of the hinge apparatus. In this implementation, the second shaft core and the base are in direct contact and in interference fit with each other through the interference fit between the second shaft core and the inner walls of the base sliding grooves.

In an implementation, the base includes two support plates that are arranged in the second direction and are spaced apart, an end of the bearing bracket is located between the two support plates, two sides of the end of the bearing bracket is rotatably connected to the two support plates in the second direction, and the second direction is parallel to the first shaft core. In this implementation, the end of the bearing bracket in the first direction is located between the two support plates. The end of the bearing bracket in the first direction is rotatably connected to the two support plates, so that the bearing bracket can rotate relative to the base.

In an implementation, the two support plates of the base are separately in interference fit with the bearing bracket. In this implementation, the support plates are in interference fit with the bearing bracket, so that a friction force generated when the bearing bracket rotates relative to the support plates can be used to increase the total torque provided by the hinge apparatus.

In an implementation, the hinge apparatus further includes a sliding plate and a shaft core fastener that are fastened to each other, the base includes two support plates that are arranged in a second direction and are spaced apart, the second direction is parallel to an axis of the second shaft core, a groove is provided on an inner side wall of each support plate, two ends of the sliding plate in the second direction are located in the grooves and are capable of sliding relative to the grooves, a part of the second shaft core is fastened to the shaft core fastener, and a part of the second shaft core is rotatably connected to the second end of the first shaft sleeve assembly.

In this implementation, second grooves of the two support plates are disposed opposite to each other, the sliding plate is located between the two second grooves, and two ends of the sliding plate slide in the second grooves in an extension direction of the second grooves. The part of the second shaft core is fastened to the shaft core fastener, and the part of the second shaft core is rotatably connected to the second end of the first shaft sleeve assembly. In other words, the second shaft core is fastened relative to the shaft core fastener, the second end of the first shaft sleeve assembly can rotate relative to the second shaft core. The first end of the first shaft sleeve assembly is sleeved on the first shaft core and is capable of rotating relative to the first shaft core. The hinge apparatus in this implementation has a compact structure, which helps reduce a volume of the hinge apparatus.

In an implementation, the sliding plate is in interference fit with the second grooves of the support plates. In this implementation, the second shaft core and the base are in indirect contact and in interference fit with each other through the interference fit between the sliding plate and the second grooves of the support plates. According to this solution, a friction force generated when the sliding plate slides in the second grooves can be used to increase the total torque provided by the hinge apparatus.

In an implementation, the part of the second shaft core is in interference fit with the second end of the first shaft sleeve assembly. According to this solution, a friction force generated when the second end of the first shaft sleeve assembly rotates relative to the part of the second shaft core can be used to increase the total torque provided by the hinge apparatus.

In an implementation, the second groove extends in the first direction, so that the sliding plate can slide relative to the base in the first direction. In this implementation, the sliding plate can slide relative to the base in the first direction. This can effectively use a size of the hinge apparatus in a length direction, thereby helping reduce a volume of the hinge apparatus.

In an implementation, the second groove extends in a fourth direction, and the fourth direction is straight with a component in the first direction. In this implementation, the sliding plate can slide relative to the base in the first direction. This can effectively use a size of the hinge apparatus in a length direction, thereby helping reduce a volume of the hinge apparatus.

In an implementation, the second groove extends in an arc direction, and the arc direction has a component in the first direction. In this implementation, the sliding plate can slide relative to the base in the first direction. This can effectively use a size of the hinge apparatus in a length direction, thereby helping reduce a volume of the hinge apparatus.

In an implementation, the hinge apparatus further includes one sliding block, the sliding block is provided with a through hole that penetrates the sliding block in a second direction, the second shaft core penetrates the through hole and is fastened to the sliding block, two ends of the second shaft core penetrate the through hole, and the second end of the first shaft sleeve assembly is sleeved on at least one end of the second shaft core and is capable of rotating relative to the second shaft core. The base includes a support plate that extends in the first direction, the sliding block has a slide groove whose opening faces the support plate, the support plate penetrates the slide groove in the first direction, and the sliding block is capable of sliding relative to the support plate, where the first direction intersects the second direction, and the second direction is parallel to an axis of the second shaft core.

In this implementation, the through hole penetrates two end faces of the sliding block in the second direction, a part between two ends of the second shaft core is fastened to the sliding block via the through hole, and the second end of the first shaft sleeve assembly is sleeved on at least one end of the second shaft core, to implement a rotatable connection between the second end of the first shaft sleeve assembly and the second shaft core.

In this implementation, the base has only one support plate, and is presented as a stiffener structure as a whole. An end that is of the sliding block and that faces the support plate is clamped to the support plate. In this way, the support plate penetrates the slide groove and is not detached from the slide groove, so that the sliding block is slidably connected to the support plate in the first direction. The slide groove communicates with the through hole, the slide groove slides in an extension direction of the support plate, a part of the second shaft core located in the through hole is fastened to the sliding block, and the two ends of the second shaft core are rotatably connected to the second end of the first shaft sleeve assembly, so that the second end of the first shaft sleeve assembly slides relative to the support plate.

In an implementation, interference fit exists at at least one of the following locations: between the second shaft core and an inner wall of the through hole, between the support plate and an inner wall of the slide groove of the sliding block, or between the second end of the first shaft sleeve assembly and the second shaft core. In this implementation, the second shaft core and the base are in indirect contact and in interference fit with each other through the interference fit between the support plate and the inner wall of the slide groove of the sliding block. According to this solution, a torque of the hinge apparatus can be increased, and further support stability of the hinge apparatus can be improved.

In an implementation, the bearing bracket and the base are in interference fit with each other, so that a torque is generated in a process in which the bearing bracket and the base rotate relative to each other. In this implementation, the bearing bracket and the base can rotate relative to each other, and the bearing bracket and the base are in interference fit with each other, so that a specific torque can be provided by using a friction force generated when the bearing bracket rotates relative to the base, and a total torque provided by the hinge apparatus is increased without increasing a volume of the hinge apparatus. This improves stability of the hinge apparatus when the hinge apparatus supports the electronic device.

In an implementation, the hinge apparatus further includes a first rotating member and a second rotating member, the first rotating member is fastened to the bearing bracket, the second rotating member is fastened to the base, and the bearing bracket is rotatably connected to the base through fit between the first rotating member and the second rotating member.

In this implementation, the first rotating member is located on a side that is of the bearing bracket and that faces the support plate, and the second rotating member is located on an inner side of the support plate. The bearing bracket rotates relative to the base, to drive the first rotating member to rotate relative to the second rotating member.

In an implementation, each of two ends of the first rotating member in the second direction includes a sliding groove, the second rotating member is a slide protrusion, a shape of the sliding groove fits a shape of the slide protrusion, and the first rotating member fits the second rotating member. According to this solution, the bearing bracket can be rotatably connected to the base.

In an implementation, the first rotating member and the bearing bracket are integrally formed, and the second rotating member and the base are integrally formed. In this implementation, stability of a rotatable connection between the bearing bracket and the base can be improved.

In an implementation, the first rotating member is in interference fit with the second rotating member. In this implementation, a torque can be provided by using a friction force generated in a process in which the first rotating member and the second rotating member rotate relative to each other, so that a total torque of the hinge apparatus is increased without increasing a volume of the hinge apparatus. In this implementation, the bearing bracket is in interference fit with the base through the interference fit between the first rotating member and the second rotating member.

In an implementation, a clamping groove is provided on a surface that is of the first rotating member and that is away from the bearing bracket, a buckle is provided on a surface that is of the bearing bracket and that faces the base, and the buckle is clamped in the clamping groove, so that the first rotating member and the bearing bracket are fastened relative to each other. In this implementation, stability of a connection between the first rotating member and the bearing bracket is further improved by using the buckle and the clamping groove.

In an implementation, the second rotating member includes two arc-shaped sliding grooves, curvature centers of the two sliding grooves are provided on a same side and are away from a bottom of the base, the first rotating member includes two arc-shaped slide protrusions, and the two slide protrusions are respectively located in the two sliding grooves and are capable of sliding relative to the sliding grooves.

In this implementation, in this solution, another first sliding groove and another first slide protrusion are added in addition to a first sliding groove and a first slide protrusion. During actual machining, curvature of the first sliding groove and curvature of the first sliding groove are adjusted through mutual matching between design tolerances, so that interference fit can be easily implemented between the first rotating member and the second rotating member. That is, when the first rotating member rotates in the second rotating member, a large friction force is generated, and therefore a torque can be provided. This helps more precisely control a movement gap.

In an implementation, the first rotating member includes a first guide rail block and a second guide rail block, the first guide rail block includes an accommodation groove whose opening is away from the bottom of the base, the second guide rail block is located in the accommodation groove and is capable of rotating relative to the first guide rail block, the first guide rail block is rotatably connected to the base, and the second guide rail block is fastened to the bearing bracket.

In this implementation, outer walls of two ends of the second guide rail block in the second direction can rotate relative to an inner wall of a first accommodation groove of the first guide rail block in the second direction, and outer walls of two ends of the first guide rail block in the second direction can rotate relative to an inner wall of the base in the second direction. In other words, the second guide rail block can rotate relative to the base for two stages. This helps increase an opening/closing angle of the second guide rail block. The second guide rail block is fastened to the bearing bracket. Because opening and closing of the bearing bracket correspond to the open state and the closed state of the hinge apparatus, an increase in the opening/closing angle of the second guide rail block helps increase the opening/closing angle of the bearing bracket. In this way, the hinge apparatus can be opened to a larger angle, to meet application requirements in different scenarios.

In an implementation, the second rotating member of the base is a second sliding groove located on an inner side of the base, where the second sliding groove is in an arc shape. Second slide protrusions are correspondingly provided at two ends of the first guide rail block in the second direction, and the second sliding groove fits the second slide protrusion, to implement a rotatable connection between the base and the first guide rail block. In an implementation, there may be one or two second sliding grooves and one or two second slide protrusions.

In an implementation, third sliding grooves are provided on inner walls of two ends of the first accommodation groove in the second direction, third slide protrusions are provided on an outer wall of the second guide rail block in the second direction, and the third sliding grooves fit the third slide protrusions. According to this solution, the first guide rail block can be rotatably connected to the second guide rail block.

In an implementation, the base is in interference fit with the first guide rail block. According to this solution, a friction force is increased, so that a torque is increased. In this implementation, the base is in interference fit with the bearing bracket through the interference fit between the base and the first guide rail block.

In an implementation, the first guide rail block is in interference fit with the second guide rail block. According to this solution, a friction force is increased, so that a torque is increased.

In an implementation, the base is in interference fit with the first guide rail block, and the first guide rail block is in interference fit with the second guide rail block. In this solution, a torque is increased through two-stage interference fit.

In an implementation, a first avoidance sub-groove is provided in the second accommodation groove, a second avoidance sub-groove is provided at an end that is of the bearing bracket and that is close to the second guide rail block, and the first avoidance sub-groove fits the second avoidance sub-groove to form an avoidance groove. The first shaft core passes through the first end of the first shaft sleeve assembly, and two ends of the first end are located in the avoidance groove formed by the first avoidance sub-groove and the second avoidance sub-groove, so that the end of the bearing bracket, the first end of the first shaft sleeve assembly, and the first shaft core are located in the second accommodation groove of the second guide rail block. According to this solution, the hinge apparatus can be smaller in size.

In an implementation, the hinge apparatus further includes a second shaft sleeve assembly, a third shaft core, and a fourth shaft core, the first shaft sleeve assembly and the second shaft sleeve assembly are located on two sides of the rotation center at which the bearing bracket rotates around the base, the third shaft core is fastened to the bearing bracket, the fourth shaft core is slidably connected to the base, a first end of the second shaft sleeve assembly is sleeved on the third shaft core and is capable of rotating relative to the third shaft core, a second end of the second shaft sleeve assembly is sleeved on the fourth shaft core and is capable of rotating relative to the fourth shaft core, and the two ends of the second shaft sleeve assembly are respectively in interference fit with the third shaft core and the fourth shaft core, to enable the second shaft sleeve assembly and each of the third shaft core and the fourth shaft core to be configured to provide a torque for the hinge apparatus in a process in which the hinge apparatus switches between the open state and the closed state.

In this implementation, two ends of the first shaft core and two ends of the third shaft core are fastened to the bearing bracket, and the second shaft core and the fourth shaft core are slidably connected to the base. The second shaft sleeve assembly includes a third shaft sleeve, a fourth shaft sleeve, and a second connecting rod. The second connecting rod is connected between the third shaft sleeve and the fourth shaft sleeve. The third shaft sleeve is located at the first end of the second shaft sleeve assembly, and the third shaft sleeve is sleeved on the third shaft core, is capable of rotating relative to the third shaft core, and is in interference fit with the third shaft core. The fourth shaft sleeve is located at the second end of the second shaft sleeve assembly, and the fourth shaft sleeve is sleeved on the fourth shaft core, is capable of rotating relative to the fourth shaft core, and is in interference fit with the fourth shaft core. The second connecting rod is configured to transmit power from the third shaft sleeve to the fourth shaft sleeve, so that the second shaft sleeve assembly rotates as a whole. The third shaft sleeve is in interference fit with the third shaft core, and the fourth shaft sleeve is in interference fit with the fourth shaft core, so that friction forces generated when the third shaft core rotates relative to the third shaft sleeve and generated when the fourth shaft core rotates relative to the fourth shaft sleeve can be used to increase a torque provided by the hinge apparatus. This improves stability of the hinge apparatus when the hinge apparatus supports the electronic device.

In an implementation, the third shaft sleeve, the second connecting rod, and the fourth shaft sleeve are integrally formed. According to this solution, stability of an overall structure of the second shaft sleeve assembly can be improved.

In an implementation, the third shaft sleeve is provided with a third opening that penetrates an inner surface and an outer surface of the third shaft sleeve, and the third opening extends in an axial direction of the third shaft sleeve. In this solution, the third opening is disposed in the third shaft sleeve, so that a rotation amplitude of the third shaft sleeve relative to the third shaft core can be increased. In addition, the third opening can be further used to increase elasticity of the third shaft sleeve, and reduce a contact area between the third shaft core and the third shaft sleeve. This helps reduce an amount of wear between the third shaft core and the third shaft sleeve, and further prolong a service life of the third shaft sleeve assembly.

In an implementation, the fourth shaft sleeve is provided with a fourth opening that penetrates an inner surface and an outer surface of the fourth shaft sleeve, and the fourth opening extends in an axial direction of the fourth shaft sleeve. In this solution, the fourth opening is disposed in the fourth shaft sleeve, so that a rotation amplitude of the fourth shaft sleeve relative to the fourth shaft core can be increased. In addition, the fourth opening can be further used to increase elasticity of the fourth shaft sleeve, and reduce a contact area between the fourth shaft core and the fourth shaft sleeve. This helps reduce an amount of wear between the fourth shaft core and the fourth shaft sleeve, and further prolong a service life of the fourth shaft sleeve assembly.

In an implementation, a third shaft sleeve plane part is provided on the inner surface of the third shaft sleeve, and a third shaft core plane part parallel to the third shaft sleeve plane part is provided on an outer surface of the third shaft core. In the closed state, the third shaft sleeve plane part and the third shaft core plane part are disposed opposite to each other. In this implementation, the third shaft sleeve plane part fits the third shaft core plane part, and in the closed state, both the third shaft sleeve plane part and the third shaft core plane part are parallel to the bottom of the base. When the hinge apparatus is in the closed state, the third shaft sleeve and the third shaft core need to be kept from rotating relative to each other. Therefore, in this solution, the third shaft sleeve plane part and the third shaft core plane part are disposed, so that the third shaft sleeve and the third shaft core can be limited in a circumferential direction. Further, the hinge apparatus is locked in the closed state.

In an implementation, a fourth shaft sleeve plane part is provided on the inner surface of the fourth shaft sleeve, and a fourth shaft core plane part parallel to the fourth shaft sleeve plane part is provided on an outer surface of the fourth shaft core. In the closed state, the fourth shaft sleeve plane part and the fourth shaft core plane part are disposed opposite to each other. In this implementation, the fourth shaft sleeve plane part fits the fourth shaft core plane part, and in the closed state, both the fourth shaft sleeve plane part and the fourth shaft core plane part are parallel to the bottom of the base. When the hinge apparatus is in the closed state, the fourth shaft sleeve and the fourth shaft core need to be kept from rotating relative to each other. Therefore, in this solution, the fourth shaft sleeve plane part and the fourth shaft core plane part are disposed, so that the fourth shaft sleeve and the fourth shaft core can be limited in a circumferential direction.

Further, the hinge apparatus is locked in the closed state.

In an implementation, the base includes a first support plate and a second support plate that are arranged in a second direction and are spaced apart, and the first support plate and the second support plate each are provided with a first base sliding groove and a second base sliding groove. The second rotating member is located between the first base sliding groove and the second base sliding groove in the first direction, the second shaft core is located in the first base sliding groove and is in interference fit with the first base sliding groove, and the fourth shaft core is located in the second base sliding groove and is in interference fit with the second base sliding groove.

In an implementation, the first base sliding groove and the second base sliding groove extend in the first direction, so that the third shaft core and the fourth shaft core can slide relative to the base in the first direction. In this implementation, the third shaft core and the fourth shaft core can slide relative to the base in the first direction. This can effectively use a size of the hinge apparatus in a length direction, thereby helping reduce a volume of the hinge apparatus.

In an implementation, the first base sliding groove and the second base sliding groove extend in a fourth direction, where the fourth direction has a component in the first direction. The fourth direction and the first direction are provided at an included angle and are both parallel to the first support plate. In this implementation, the third shaft core and the fourth shaft core can slide relative to the base in the first direction. This can effectively use a size of the hinge apparatus in a length direction, thereby helping reduce a volume of the hinge apparatus.

In an implementation, the first base sliding groove and the second base sliding groove extend in an arc direction, where the arc direction has a component in the first direction. In this implementation, the third shaft core and the fourth shaft core can slide relative to the base in the first direction. This can effectively use a size of the hinge apparatus in a length direction, thereby helping reduce a volume of the hinge apparatus.

According to a second aspect, an embodiment of this application provides a hinge apparatus. The hinge apparatus has an open state and a closed state. The hinge apparatus includes a base, a bearing bracket, a first shaft core, a second shaft core, and a first shaft sleeve assembly. The bearing bracket is rotatably connected to the base, for the bearing bracket to be opened or closed relative to the base. The first shaft core is fastened to the bearing bracket. The second shaft core is slidably connected to the base. A first end of the first shaft sleeve assembly is sleeved on the first shaft core and is capable of rotating relative to the first shaft core, and a second end of the first shaft sleeve assembly is sleeved on the second shaft core and is capable of rotating relative to the second shaft core. The first end of the first shaft sleeve assembly is in interference fit with the first shaft core, and interference fit exists at at least one of the following locations: between the second end of the first shaft sleeve assembly and the second shaft core, between the second shaft core and the base, or between the bearing bracket and the base, to provide a torque for the hinge apparatus at a location of the interference fit in a process in which the hinge apparatus switches between the open state and the closed state.

In this implementation, an overall torque of the hinge apparatus can be increased. In this way, the hinge apparatus can support a larger electronic device or support the electronic device at a large angle. Alternatively, when the supported electronic device is determined, a volume of the hinge apparatus may be reduced, which helps implement a light and thin design of the entire electronic device.

It should be noted that any one of the implementations of the hinge apparatus provided in the first aspect is applicable to the hinge apparatus provided in the second aspect.

According to a third aspect, an embodiment of this application provides an electronic device. The electronic device includes a device body, a support member, and the hinge apparatus according to any one of the implementations of the first aspect. The hinge apparatus is located between the device body and the support member, the bearing bracket in the hinge apparatus is fastened to the support member, and the base in the hinge apparatus is fastened to the device body. When the hinge apparatus is in the open state, the support member is open relative to the device body via the hinge apparatus, and the support member is configured to support the device body. When the hinge apparatus according to any one of the implementations of the first aspect is used in the electronic device, because the hinge apparatus provides a large torque, the electronic device can be stably supported, to meet a requirement of the electronic device for large-angle support.

According to a fourth aspect, an embodiment of this application provides a housing. The housing includes a housing body, a support member, and the hinge apparatus according to any one of the implementations of the first aspect. The hinge apparatus is located between the housing body and the support member, the bearing bracket in the hinge apparatus is fastened to the support member, and the base in the hinge apparatus is fastened to the housing body. When the hinge apparatus is in the open state, the support member is open relative to the housing body via the hinge apparatus. When the hinge apparatus according to any one of the implementations of the first aspect is used in the housing, because a torque provided by the hinge apparatus is large, the housing can be stably supported. When the housing is configured to accommodate a functional component, a requirement of the housing for large-angle support can be met. Alternatively, when a functional component accommodated in the housing is heavy, a sufficient torque can be provided to support the functional component in the housing.

### BRIEF DESCRIPTION OF DRAWINGS

To describe technical solutions in embodiments of this application more clearly, the following describes the accompanying drawings used in embodiments of this application.
FIG. 1 is a diagram of a structure of an electronic device in a closed state according to an embodiment of this application;
FIG. 2a is a diagram of a structure of an electronic device in an open state at an angle according to an embodiment of this application;
FIG. 2b is a diagram of a structure of an electronic device in an open state at another angle according to an embodiment of this application;
FIG. 3 is an exploded view of an electronic device according to an embodiment of this application;
FIG. 4a is a diagram of a structure of a housing in a closed state according to an embodiment of this application;
FIG. 4b is a diagram of a structure of a housing in an open state according to an embodiment of this application;
FIG. 5 is a diagram of a structure of a hinge apparatus in an open state according to a first embodiment of this application;
FIG. 6 is a diagram of a structure of the hinge apparatus shown in FIG. 5 in a closed state;
FIG. 7 is an exploded view of the hinge apparatus shown in FIG. 5;
FIG. 8 is a diagram of analysis of forces exerted on a hinge apparatus and a support member according to a first embodiment of this application;
FIG. 9 is a diagram of analysis of forces exerted on a first shaft core, a second shaft core, a virtual central axis, and a support member according to an embodiment of this application;
FIG. 10 is a diagram of analysis of forces exerted on a first shaft core, a second shaft core, a virtual central axis, and a support member according to an embodiment of this application;
FIG. 11 is a diagram of analysis of forces exerted on a first shaft core, a second shaft core, a virtual central axis, and a support member according to an embodiment of this application;
FIG. 12 is a diagram of analysis of forces exerted on a first shaft core, a second shaft core, a virtual central axis, and a support member according to an embodiment of this application;
FIG. 13 is a diagram of analysis of forces exerted on a first shaft core, a second shaft core, a virtual central axis, and a support member according to an embodiment of this application;
FIG. 14 is a sectional view of the hinge apparatus shown in FIG. 5 according to the first embodiment;
FIG. 15 is a diagram of a partial structure of the hinge apparatus shown in FIG. 5 according to the first embodiment;
FIG. 16 is a diagram of a partial structure of the hinge apparatus shown in FIG. 5 according to the first embodiment;
FIG. 17 is a diagram of a partial structure of the hinge apparatus shown in FIG. 5 according to the first embodiment;
FIG. 18 is a diagram of a structure of a first shaft sleeve and a second shaft sleeve in a hinge apparatus according to a first embodiment of this application;
FIG. 19 is a diagram of a structure of a first shaft sleeve and a first shaft core in a hinge apparatus according to a first embodiment of this application;
FIG. 20 is a diagram of a partial structure of a hinge apparatus according to a first embodiment of this application;
FIG. 21 is a diagram of a structure of a first shaft sleeve and a first shaft core in a hinge apparatus according to a first embodiment of this application;
FIG. 22 is a diagram of a structure of a second shaft sleeve in a hinge apparatus according to a first embodiment of this application;
FIG. 23 is a diagram of a structure of a hinge apparatus according to an embodiment of this application;
FIG. 24 is a diagram of a structure of a hinge apparatus in an open state according to a second embodiment of this application;
FIG. 25 is a diagram of a structure of the hinge apparatus shown in FIG. 24 in a closed state according to the second embodiment;
FIG. 26 is an exploded view of the hinge apparatus shown in FIG. 24 according to the second embodiment;
FIG. 27 is a diagram of a partial structure of the hinge apparatus shown in FIG. 24 according to the second embodiment;
FIG. 28 is a diagram of a partial structure of the hinge apparatus shown in FIG. 24 according to the second embodiment;
FIG. 29 is a diagram of a partial structure of the hinge apparatus shown in FIG. 24 according to the second embodiment;
FIG. 30 is a diagram of a structure of a hinge apparatus in an open state according to a third embodiment of this application;
FIG. 31 is a diagram of a structure of the hinge apparatus shown in FIG. 30 in a closed state according to the third embodiment;
FIG. 32 is an exploded view of the hinge apparatus shown in FIG. 30 according to the third embodiment;
FIG. 33 is a diagram of a structure of a hinge apparatus in a closed state according to a fourth embodiment of this application;
FIG. 34 is an exploded view of the hinge apparatus shown in FIG. 33 according to the fourth embodiment;
FIG. 35 is a diagram of a partial structure of the hinge apparatus shown in FIG. 33 according to the fourth embodiment;
FIG. 36 is a diagram of a structure of a hinge apparatus in an open state according to a fifth embodiment of this application;
FIG. 37 is a diagram of a structure of the hinge apparatus shown in FIG. 36 in a closed state according to the fifth embodiment; and
FIG. 38 is an exploded view of the hinge apparatus shown in FIG. 36 according to the fifth embodiment.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

Terms "first", "second", and the like in this specification are merely intended for a purpose of description, and shall not be understood as an indication or implication of relative importance or an implicit indication of a quantity of indicated technical features. Therefore, a feature limited by "first" or "second" may explicitly or implicitly include one or more features. In descriptions of this application, unless otherwise stated, "a plurality of" means two or more than two.

In addition, in this specification, location terms such as "top" and "bottom" are defined relative to locations of structures in the accompanying drawings. It should be understood that these location terms are relative concepts used for relative description and clarification, and may correspondingly change based on changes in the locations of the structures.

For ease of understanding, the following first explains and describes English abbreviations and related technical terms in embodiments of this application.

Rotation connection: That a part A is rotatably connected to a part B means that the part A and the part B are connected to each other and can rotate relative to each other.

Sliding connection: That a part A is slidably connected to a part B means that the part A and the part B are connected to each other and can slide relative to each other after being connected.

Perpendicularity: Perpendicularity defined in this application is not limited to an absolute perpendicular intersection (an included angle is 90 degrees) relationship. A non-absolute perpendicular intersection relationship caused by factors such as impact of an assembly tolerance, a design tolerance, and structural flatness is allowed. An error within a small angle range is allowed. For example, an intersection relationship within an assembly error range of 80 degrees to 100 degrees may be understood as a perpendicularity relationship.

Parallelism: Parallelism defined in this application is not limited to absolute parallelism. A definition of the parallelism may be understood as being substantially parallel. Non-absolute parallelism caused by factors such as impact of an assembly tolerance, a design tolerance, and structural flatness is allowed.

MIM: Metal Injection Molding, which means metal injection molding.

Interference fit: The interference fit between a part A and a part B means that an outer diameter of the part A is greater than an inner diameter of a through hole of the part B, and the part A penetrates the through hole of the part B, for the part A and the part B to be in interference fit with each other to generate a torque.

Embodiments of this application provide a hinge apparatus having an open state and a closed state. The hinge apparatus includes a base, a bearing bracket, a first shaft core, a second shaft core, and a first shaft sleeve assembly. The bearing bracket is rotatably connected to the base, for the bearing bracket to be opened or closed relative to the base. The first shaft core is fastened to the bearing bracket. The second shaft core is slidably connected to the base. A first end of the first shaft sleeve assembly is sleeved on the first shaft core and is capable of rotating relative to the first shaft core, a second end of the first shaft sleeve assembly is sleeved on the second shaft core and is capable of rotating relative to the second shaft core, and the two ends of the first shaft sleeve assembly are respectively in interference fit with the first shaft core and the second shaft core, to enable the first shaft sleeve assembly and each of the first shaft core and the second shaft core to be configured to provide a torque for the hinge apparatus in a process in which the hinge apparatus switches between the open state and the closed state. According to the hinge apparatus provided in embodiments of this application, the first shaft sleeve assembly is separately in interference fit with the first shaft core and the second shaft core to provide torques, so that the electronic device can be stably supported at an angle set by a user, and a requirement for large-angle support is met.

The hinge apparatus provided in embodiments of this application may be used in an electronic device.

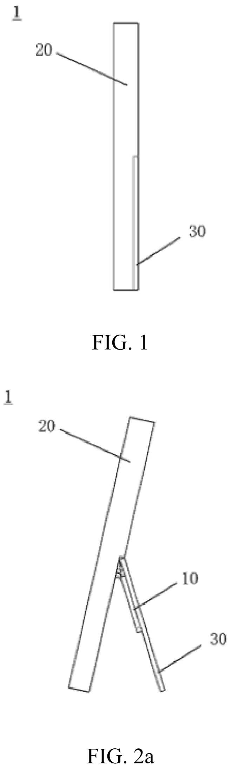

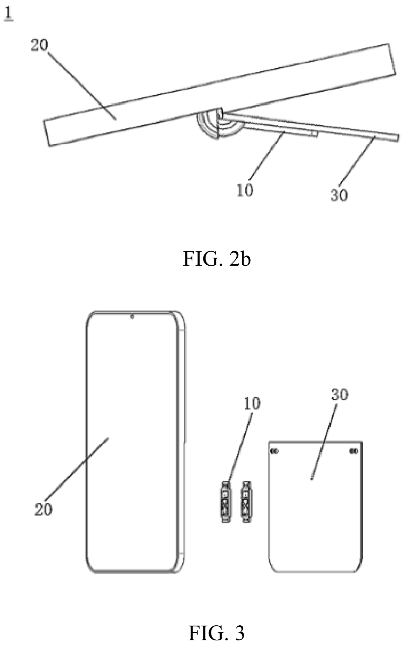

Refer to FIG. 1 to FIG. 3. FIG. 1 is a diagram of a structure of an electronic device 1 in a closed state according to an embodiment of this application. FIG. 2a is a diagram of a structure of the electronic device 1 in an open state at an angle according to an embodiment of this application. FIG. 2b is a diagram of a structure of the electronic device 1 in an open state at another angle according to an embodiment of this application. FIG. 3 is an exploded view of the electronic device 1 according to an embodiment of this application.

In an implementation, the electronic device 1 includes a device body 20, a support member 30, and a hinge apparatus 10 (as shown in FIG. 3). The hinge apparatus 10 is located between the device body 20 and the support member 30, a bearing bracket of the hinge apparatus 10 is fastened to the support member 30 (as shown in FIG. 2a and FIG. 2b), and a base of the hinge apparatus 10 is fastened to the device body 20 (as shown in FIG. 2a and FIG. 2b). The base and the bearing bracket of the hinge apparatus 10 are not shown in FIG. 2a and FIG. 2b. When the hinge apparatus 10 is in the open state, the support member 30 is open relative to the device body 20 via the hinge apparatus 10, and the support member 30 is configured to support the device body 20.

In this implementation, the support member 30 is configured to: enable a user to exert an acting force, and support the device body 20. The hinge apparatus 10 is configured to: rotate the support member 30, and provide a torque to maintain the support member 30 at a specific opening/closing angle. The bearing bracket of the hinge apparatus 10 is fastened to the support member 30, and the base of the hinge apparatus 10 is fastened to the device body 20. In an opening and closing process of the electronic device 1, an included angle between the bearing bracket of the hinge apparatus 10 and the support member 30 remains unchanged, and an included angle between the base of the hinge apparatus 10 and the device body 20 remains unchanged.

In an implementation, the electronic device includes but is not limited to a two-in-one product, an integrated computer, and a mobile phone. The two-in-one product usually includes a host and a keyboard assembly. The host and the keyboard assembly are detachably connected. After the host is separated from the keyboard assembly, the host can still be used as an independent electronic device. For example, the host may be a tablet computer. The host is the device body 20 in the electronic device 1. The support member 30 is located on a back side of the host and is configured to support the host. The hinge apparatus 10 is located between the host and the support member.

During actual use of the user, as shown in FIG. 1, when the electronic device 1 is in the closed state, the support member 30 is closed with the device body 20, and the hinge apparatus 10 is located between the support member 30 and the device body 20. An acting force is exerted on the support member 30. Because the support member 30 is fastened to the bearing bracket of the hinge apparatus 10, the bearing bracket of the hinge apparatus 10 is also subject to the same acting force and presents a corresponding opening/closing angle relative to the base. In this case, if the torque provided by the hinge apparatus 10 is small, although the user can easily open and close the hinge apparatus 10, the hinge apparatus 10 cannot stably maintain a specific opening/closing angle. Especially when an opening angle is large, the hinge apparatus 10 is prone to toppling, and consequently, the device body 20 may be damaged. FIG. 2a and FIG. 2b are diagrams in which the electronic device 1 is open at different angles. An opening angle in FIG. 2b is greater than an opening angle in FIG. 2a, and therefore, the hinge apparatus 10 shown in FIG. 2b needs to provide a larger torque to support the electronic device 1.

However, in embodiments of this application, the hinge apparatus 10 is improved, so that the torque provided by the hinge apparatus 10 can be increased, and further the hinge apparatus 10 can more stably support the electronic device 1.

In an implementation, the hinge apparatus 10 in this application may be further used in a protective cover. For example, the protective cover is mounted outside an electronic device, and the protective cover is opened to support the electronic device. For example, the protective cover may be a leather protective cover.

In an implementation, the hinge apparatus 10 in this application may be further used in another mechanical part or product that needs to be supported, to provide a large torque, so as to more stably support the mechanical part or the product.

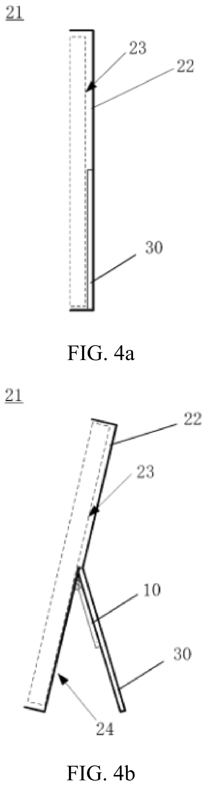

Refer to FIG. 4a and FIG. 4b. FIG. 4a is a diagram of a structure of a housing 21 in a closed state according to an embodiment of this application. FIG. 4b is a diagram of a structure of the housing 21 in an open state according to an embodiment of this application. In this embodiment, the housing 21 includes a housing body 22, a support member 30, and a hinge apparatus 10. The hinge apparatus 10 is located between the housing body 22 and the support member 30, a bearing bracket of the hinge apparatus 10 is fastened to the support member 30, and a base of the hinge apparatus 10 is fastened to the housing body 22. When the hinge apparatus 10 is in the open state, the support member 30 is open relative to the housing body 22 via the hinge apparatus 10.

The housing body 22 is configured to accommodate a functional component. As shown in FIG. 4b, a dashed box in the housing body 22 indicates an accommodation cavity 23 in the housing body 22, where the accommodation cavity 23 is configured to accommodate the functional component.

In some embodiments, an electronic device 1 includes a plurality of functional components (not shown in the figure), and the plurality of functional components may be mounted inside the housing body 22. The plurality of functional components may include, for example, a display, a middle frame, a camera module, a processor, an internal memory, an external memory interface, a universal serial bus (universal serial bus, USB) interface, a charging management module, a power management module, a battery, an antenna, a communication module, a camera, an audio module, a speaker, a receiver, a microphone, a headset jack, a sensor module, a button, a motor, an indicator, and a subscriber identity module (subscriber identity module, SIM) card interface. The electronic device 1 may have more or fewer components than those described above, or a combination of two or more components, or an arrangement of different components. Various components may be implemented in hardware, software, or a combination of hardware and software including one or more signal processing and/or application-specific integrated circuits.

For example, the electronic device 1 is a tablet computer, and the housing 21 is a housing of the tablet computer. For example, the electronic device 1 is a mobile phone, and the housing 21 is a housing of the mobile phone.

In an implementation, the support member 30 is located on a back side of the housing body 22. A front side of the housing body 22 is configured to accommodate the functional component. For example, when the housing 21 is the housing of the tablet computer, the front side of the housing body 22 is a display side of the tablet computer. The back side and the display side of the housing body 22 are disposed opposite to each other.

In an implementation, there is an accommodation groove 24 (as shown in FIG. 4b) on a surface that is of the housing body 22 and that faces the support member 30. The accommodation groove 24 is configured to accommodate the support member 30, so that a back surface of the housing 21 remains flat when the housing 21 is in a closed state. For example, the accommodation groove 24 may include a groove wall, and the support member 30 is located in an area enclosed by the groove wall. For example, the accommodation groove 24 is an avoidance groove on a back surface of the housing body 22, and has no groove wall.

The following describes a possible implementation of the hinge apparatus 10 according to a first embodiment of this application.

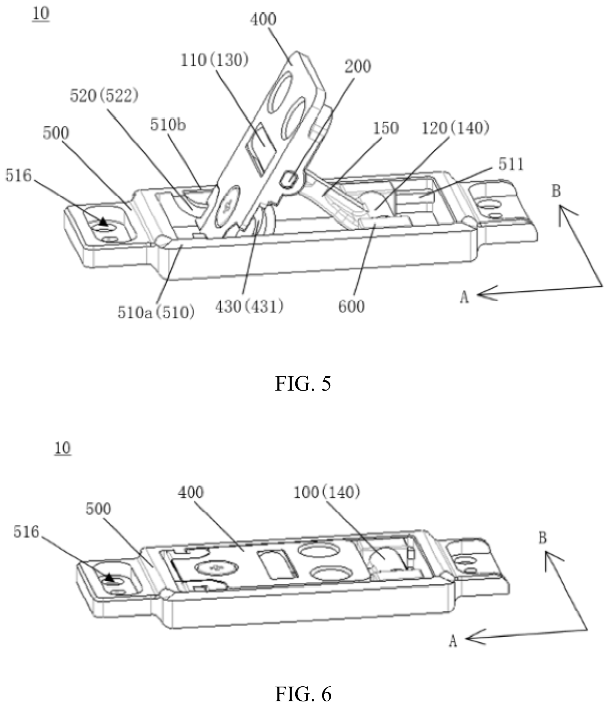

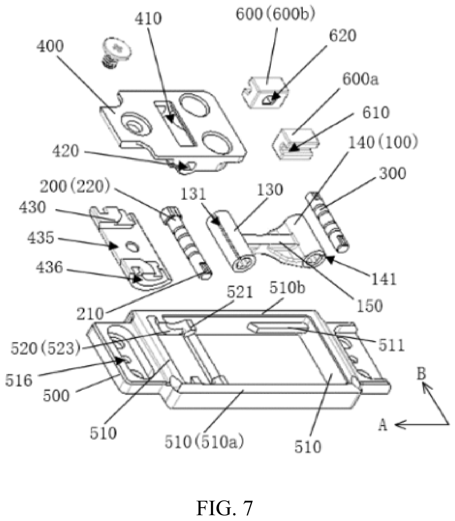

Refer to FIG. 5 to FIG. 7. FIG. 5 is a diagram of a structure of the hinge apparatus 10 in an open state according to the first embodiment of this application. FIG. 6 is a diagram of a structure of the hinge apparatus 10 shown in FIG. 5 in a closed state. FIG. 7 is an exploded view of the hinge apparatus 10 shown in FIG. 5.

In an implementation, the hinge apparatus 10 has an open state and a closed state, and the hinge apparatus 10 includes a base 500, a bearing bracket 400, a first shaft core 200, a second shaft core 300, and a first shaft sleeve assembly 100 (as shown in FIG. 5 and FIG. 7). The bearing bracket 400 is rotatably connected to the base 500, for the bearing bracket 400 to be opened or closed relative to the base 500 (with reference to FIG. 5 and FIG. 6). The first shaft core 200 is fastened to the bearing bracket 400 (as shown in FIG. 5). The second shaft core 300 is slidably connected to the base 500 (with reference to FIG. 5 to FIG. 7). A first end 110 of the first shaft sleeve assembly 100 is sleeved on the first shaft core 200 and is capable of rotating relative to the first shaft core 200 (with reference to FIG. 5 to FIG. 7), a second end 120 of the first shaft sleeve assembly 100 is sleeved on the second shaft core 300 and is capable of rotating relative to the second shaft core 300 (with reference to FIG. 5 to FIG. 7), and the two ends of the first shaft sleeve assembly 100 are respectively in interference fit with the first shaft core 200 and the second shaft core 300, to enable the first shaft sleeve assembly 100 and each of the first shaft core 200 and the second shaft core 300 to be configured to provide a torque for the hinge apparatus 10 in a process in which the hinge apparatus 10 switches between the open state and the closed state.

In this implementation, opening and closing of the bearing bracket 400 relative to the base 500 correspond to the open state and the closed state of the hinge apparatus 10. The hinge apparatus 10 is fastened to the support member 30 via the bearing bracket 400. A user exerts an acting force on the support member 30, for the bearing bracket 400 to rotate relative to the base 500. Further, the hinge apparatus 10 switches between the open state and the closed state.

In this implementation, the first shaft sleeve assembly 100 can rotate relative to the bearing bracket 400 and the base 500. The two ends of the first shaft sleeve assembly 100 are of a hollow structure, the first shaft core 200 and the second shaft core 300 are respectively configured to support the two ends of the first shaft sleeve assembly 100, and inner walls of the two ends of the first shaft sleeve assembly 100 are respectively in interference fit with outer walls of the first shaft core 200 and the second shaft core 300. The interference fit is pressed fit or a fit manner in which a torque and a friction force can be generated. When the first end 110 of the first shaft sleeve assembly 100 is in interference fit with the first shaft core 200, the first end 110 of the first shaft sleeve assembly 100 and the first shaft core 200 can still rotate relative to each other. However, when the first end 110 of the first shaft sleeve assembly 100 rotates relative to the first shaft core 200, an acting force needs to be exerted on the bearing bracket 400, and the first end 110 of the first shaft sleeve assembly 100 is in interference fit with the first shaft core 200 to provide a torque, so that a required opening/closing angle can be maintained between the first end 110 of the first shaft sleeve assembly 100 and the first shaft core 200 when the first end 110 of the first shaft sleeve assembly 100 and the first shaft core 200 rotate relative to each other. A similar principle applies to the second end 120 of the first shaft sleeve assembly 100 and the second shaft core 300.

In the hinge apparatus 10, in comparison with that the torque is provided only at the first shaft core 200, torques can be provided at two locations in the hinge apparatus 10 in embodiments of this application, and the torques are provided through interference fit at locations at which the two ends of the first shaft sleeve assembly 100 are connected to the first shaft core 200 and the second shaft core 300, so that an overall torque is increased. In one aspect, because the overall torque is increased, resistance to the user is increased when the user pushes the support member 30. In this way, the user can more precisely control an opening/closing angle, to meet use requirements of the user in different scenarios. In another aspect, after the user determines the opening/closing angle of the electronic device 1, because the hinge apparatus 10 has a large torque, the opening/closing angle of the electronic device 1 is not prone to changing, in other words, the hinge apparatus 10 can stably support the electronic device 1, and is not prone to toppling even at a large opening/closing angle. This helps prevent the electronic device 1 from being damaged.

The following describes a location relationship between a virtual central axis and each of the first shaft core 200 and the second shaft core 300 and analysis of forces thereof.

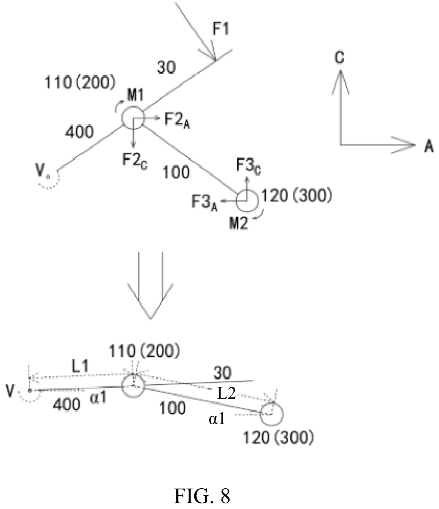

FIG. 8 is a diagram of analysis of forces exerted on the hinge apparatus 10 and the support member 30 according to a first embodiment of this application. In an implementation, a rotation center at which the bearing bracket 400 rotates around the base 500 is denoted as a virtual central axis V, and the first shaft core 200 and the second shaft core 300 are parallel to the virtual central axis V. In the open state, the virtual central axis V, the first shaft core 200, and the second shaft core 300 are spaced apart in a first direction A. In this implementation, in the open state, in the first direction A, the virtual central axis V and the second shaft core 300 are located on two sides of the first shaft core 200. For example, as shown in FIG. 8, the virtual central axis V is located on a left side of the first shaft core 200, and the second shaft core 300 is located on a right side of the first shaft core 200.

In this implementation, FIG. 8 is a diagram of analysis of a force exerted on the hinge apparatus 10 shown in FIG. 6, an upper figure in FIG. 8 is a diagram of the hinge apparatus 10 in the open state, and a lower figure in FIG. 8 is a diagram of the hinge apparatus 10 in the closed state. In a process in which the user exerts an acting force F1 on the support member 30 to close the hinge apparatus 10, the support member 30 rotates clockwise, the first end 110 of the first shaft sleeve assembly 100 rotates counterclockwise relative to the bearing bracket 400, there is a clockwise torque M1 between the first end 110 of the first shaft sleeve assembly 100 and the first shaft core 200, and the bearing bracket 400 exerts an acting force F2 (not shown in the figure) on the first end 110 of the first shaft sleeve assembly 100. F2 has a rightward component force F2_{A} in the first direction A and a downward component force F2c in a third direction C. The second end 120 of the first shaft sleeve assembly 100 rotates counterclockwise relative to the base 500, there is a clockwise torque M2 between the second end 120 of the first shaft sleeve assembly 100 and the second shaft core 300, and the base 500 exerts resistance F3 (not shown in the figure) on the second end 120 of the first shaft sleeve assembly 100. F3 has a leftward component force F3_{A} in the first direction A and an upward component force F3c in the third direction C.

In this implementation, the first direction A is perpendicular to the first shaft core 200, and the first direction A is parallel to a surface that is of the base 500 and that faces the device body. In an implementation, the first direction A is a length direction of the hinge apparatus 10.

The following uses the first shaft core 200 and the second shaft core 300 in FIG. 8 as an example to describe a case of setting two torques in the hinge apparatus 10 to increase an overall torque value of the hinge apparatus 10. Still refer to the lower figure in FIG. 8. In an implementation, a line segment between the first shaft core 200 and a location at which the bearing bracket 400 and the base 500 are rotatably connected is a first line segment L1. In the closed state, a first included angle α1 is formed between the first line segment L1 and the first direction A. A line segment between the first shaft core 200 and the second shaft core 300 is a second line segment L2. In the closed state, a second included angle α2 is formed between the second line segment L2 and the first direction A. A total torque of the hinge apparatus 10 meets a relational expression M=aM1+bM2.

Herein, M is the total torque of the hinge apparatus 10, M1 is a torque provided by the first end 110 of the first shaft sleeve assembly 100 and the first shaft core 200, M2 is a torque provided by the second end 120 of the first shaft sleeve assembly 100 and the second shaft core 300, both a and b are coefficients related to a size value of the first line segment L1, a size value of the second line segment L2, a value of the first included angle α1, and a value of the second included angle α2. A value of M1 is related to a degree of interference fit between the first end 110 of the first shaft sleeve assembly 100 and the first shaft core 200. For example, when an outer diameter of the first shaft core 200 is greater than an inner diameter of a through hole at the first end 110 of the first shaft sleeve assembly 100, and a difference between the outer diameter of the first shaft core 200 and the inner diameter of the through hole at the first end 110 of the first shaft sleeve assembly 100 is large, the value of M1 is larger. A value of M2 is related to a degree of interference fit between the second end 120 of the first shaft sleeve assembly 100 and the second shaft core 300. In some implementations, the value of M1 is further related to roughness of a surface on which the first end 110 of the first shaft sleeve assembly 100 is in contact with the first shaft core 200, and the value of M2 is further related to roughness of a surface on which the second end 120 of the first shaft sleeve assembly 100 is in contact with the second shaft core 300. In conclusion, the values of M1 and M2 have been determined after the hinge apparatus 10 is prepared. In a process of switching between the open state and the closed state of the hinge apparatus 10, the values of M1 and M2 do not change.

In a process in which the hinge apparatus 10 switches from the closed state to the open state, the size values of the first line segment L1 and the second line segment L2 do not change, and the values of the first included angle α1 and the second included angle α2 continuously change. During a design of the hinge apparatus 10, values of L1 and L2 and initial values of α1 and α2 in the closed state are set, so that in a process of opening the hinge apparatus 10, a value of M may continuously increase as the values of the first included angle α1 and the second included angle α2 continuously change. If only one torque is set in the hinge apparatus 10, M is equal to M1 in a process of opening the hinge apparatus 10. Although the first included angle α1 also changes, the value of M1 is not related to α1. In this way, M remains unchanged in the process of opening the hinge apparatus 10.

In this implementation, when the hinge apparatus 10 is in the closed state, an acting force (namely, gravity) exerted by the electronic device on the hinge apparatus 10 is borne by the hinge apparatus 10 as a whole. In the process in which the hinge apparatus 10 switches from the closed state to the open state, when an opening angle becomes larger, a larger torque is required to support the electronic device. It can be learned from the foregoing relational expression M=aM1+bM2 that, in the process in which the hinge apparatus 10 switches from the closed state to the open state, M continuously increases as the values of the first included angle α1 and the second included angle α2 continuously change. Therefore, the hinge apparatus 10 provided in this embodiment of this application can adapt to a requirement on a torque for large-angle support, to ensure stability of the hinge apparatus 10.

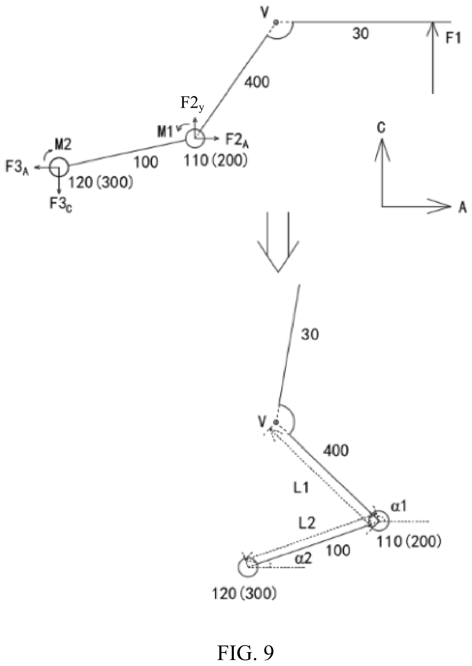

FIG. 9 to FIG. 13 below show other possible implementations of relative locations between the first shaft core 200, the second shaft core 300, and the virtual central axis V according to an embodiment of this application.

Example 1: FIG. 9 is a diagram of analysis of forces exerted on the first shaft core 200, the second shaft core 300, the virtual central axis V, and the support member 30 according to an embodiment of this application. In an implementation, in the closed state, in a first direction A, the first shaft core 200 is located between the second shaft core 300 and the virtual central axis V, and the first direction A is perpendicular to the virtual central axis V and parallel to a surface that is of the base 500 and that faces the bearing bracket 400. For example, as shown in FIG. 9, the second shaft core 300 and the virtual central axis V are respectively located on left and right sides of the first shaft core 200 in the first direction A. Both the first shaft core 200 and the second shaft core 300 are located on a left side of the virtual central axis V in the first direction A.

In this implementation, the first direction A is a length direction of the hinge apparatus 10. An upper figure in FIG. 9 is a diagram of the hinge apparatus 10 in the closed state, and a lower figure in FIG. 9 is a diagram of the hinge apparatus 10 in the open state. In a process in which the user exerts an acting force F1 on the support member 30 to open the hinge apparatus 10, the support member 30 rotates counterclockwise, the first end 110 of the first shaft sleeve assembly 100 rotates clockwise relative to the bearing bracket 400, there is a counterclockwise torque M1 between the first end 110 of the first shaft sleeve assembly 100 and the first shaft core 200, and the bearing bracket 400 exerts an acting force F2 on the first end 110 of the first shaft sleeve assembly 100. F2 has a rightward component force F2_{A} in the first direction A and an upward component force F2c in a third direction C. The second end 120 of the first shaft sleeve assembly 100 rotates counterclockwise relative to the base 500, there is a clockwise torque M2 between the second end 120 of the first shaft sleeve assembly 100 and the second shaft core 300, and the base 500 exerts an acting force F3 on the second end 120 of the first shaft sleeve assembly 100. F3 has a leftward component force F3_{A} in the first direction A and a downward component force F3c in the third direction C. The third direction C is perpendicular to the first direction A and is perpendicular to the surface that is of the base 500 and that faces the bearing bracket 400, or the third direction C is perpendicular to a surface that is of the base 500 and that faces the device body.

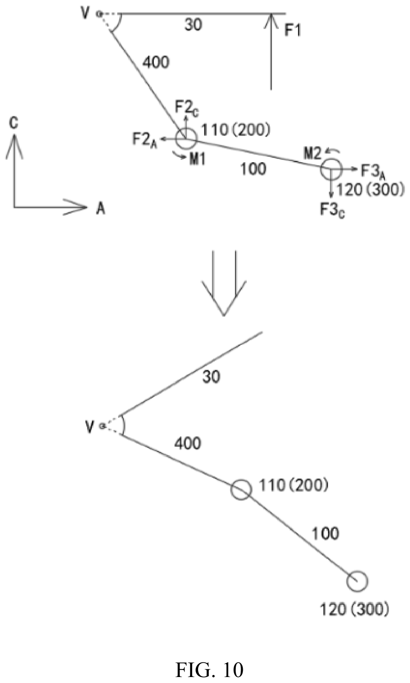

Example 2: FIG. 10 is a diagram of analysis of forces exerted on the first shaft core 200, the second shaft core 300, the virtual central axis V, and the support member 30 according to an embodiment of this application. In an implementation, in the closed state, in a first direction A, the second shaft core 300 is located between the virtual central axis V and the first shaft core 200. For example, as shown in FIG. 10, the virtual central axis V and the second shaft core 300 are respectively located on left and right sides of the first shaft core 200 in the first direction A. Both the first shaft core 200 and the second shaft core 300 are located on a right side of the virtual central axis V in the first direction A.

In this implementation, an upper figure in FIG. 10 is a diagram of the hinge apparatus 10 in the closed state, and a lower figure in FIG. 10 is a diagram of the hinge apparatus 10 in the open state. In a process in which the user exerts an acting force F1 on the support member 30 to open the hinge apparatus 10, the support member 30 rotates counterclockwise, the first end 110 of the first shaft sleeve assembly 100 rotates clockwise relative to the bearing bracket 400, there is a counterclockwise torque M1 between the first end 110 of the first shaft sleeve assembly 100 and the first shaft core 200, and the bearing bracket 400 exerts an acting force F2 on the first end 110 of the first shaft sleeve assembly 100. F2 has a leftward component force F2_{A} in the first direction A and an upward component force F2c in a third direction C. The second end 120 of the first shaft sleeve assembly 100 rotates clockwise relative to the base 500, there is a counterclockwise torque M2 between the second end 120 of the first shaft sleeve assembly 100 and the second shaft core 300, and the base 500 exerts resistance F3 on the second end 120 of the first shaft sleeve assembly 100. F3 has a rightward component force F3_{A} in the first direction A and a downward component force F3c in the third direction C.

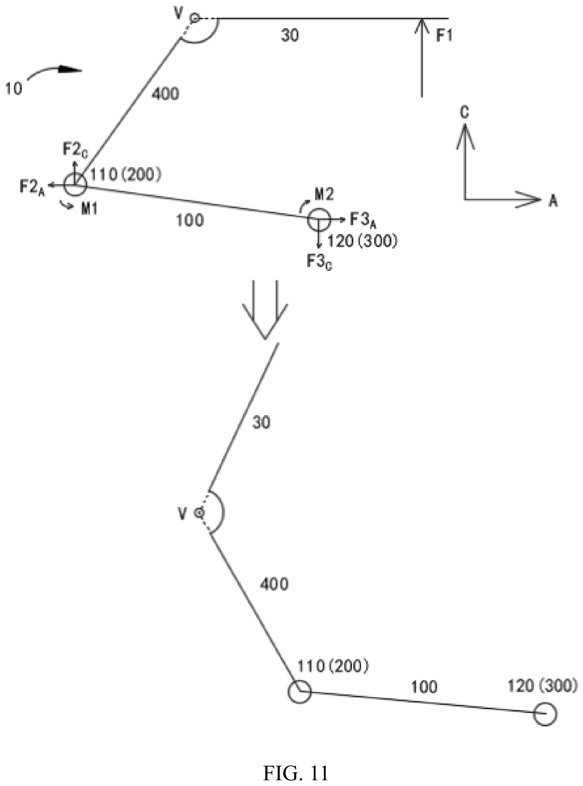

Example 3: FIG. 11 is a diagram of analysis of forces exerted on the first shaft core 200, the second shaft core 300, the virtual central axis V, and the support member 30 according to an embodiment of this application. In an implementation, in the closed state, in a first direction A, the virtual central axis V is located between the first shaft core 200 and the second shaft core 300. In this implementation, the first shaft core 200 is located on one side of the virtual central axis V in the first direction A, and the second shaft core 300 is located on the other side of the virtual central axis V in the first direction A. For example, as shown in FIG. 11, the first shaft core 200 is located on a left side of the virtual central axis V in the first direction A, and the second shaft core 300 is located on a right side of the virtual central axis V in the first direction A.

In this implementation, an upper figure in FIG. 11 is a diagram of the hinge apparatus 10 in the closed state, and a lower figure in FIG. 11 is a diagram of the hinge apparatus 10 in the open state. In a process in which the user exerts an acting force F1 on the support member 30 to open the hinge apparatus 10, the support member 30 rotates counterclockwise, the first end 110 of the first shaft sleeve assembly 100 rotates clockwise relative to the bearing bracket 400, there is a counterclockwise torque M1 between the first end 110 of the first shaft sleeve assembly 100 and the first shaft core 200, and the bearing bracket 400 exerts an acting force F2 on the first end 110 of the first shaft sleeve assembly 100. F2 has a leftward component force F2_{A} in the first direction A and an upward component force F2c in a third direction C. The second end 120 of the first shaft sleeve assembly 100 rotates counterclockwise relative to the base 500, there is a clockwise torque M2 between the second end 120 of the first shaft sleeve assembly 100 and the second shaft core 300, and the base 500 exerts resistance F3 on the second end 120 of the first shaft sleeve assembly 100. F3 has a rightward component force F3_{A} in the first direction A and a downward component force F3c in the third direction C.

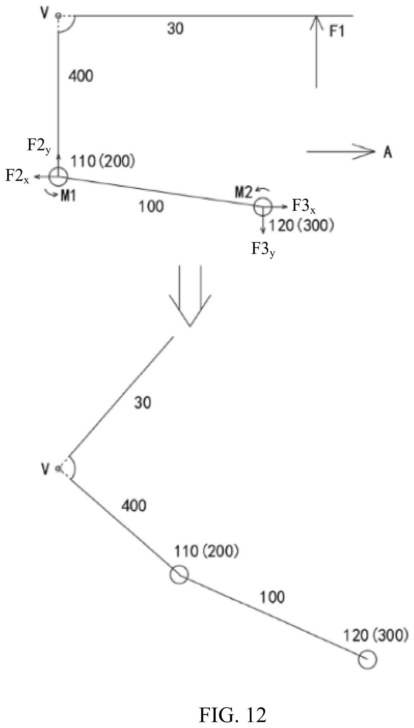

Example 4: FIG. 12 is a diagram of analysis of forces exerted on the first shaft core 200, the second shaft core 300, the virtual central axis V, and the support member 30 according to an embodiment of this application. In an implementation, in the closed state, the first shaft core 200 coincides with the virtual central axis V in a first direction A, and the second shaft core 300 and the virtual central axis V are spaced apart in the first direction A. In this implementation, the second shaft core 300 is located on a side of the virtual central axis V in the first direction A. For example, as shown in FIG. 12, the second shaft core 300 is located on a right side of the virtual central axis V in the first direction A.

In this implementation, an upper figure in FIG. 12 is a diagram of the hinge apparatus 10 in the closed state, and a lower figure in FIG. 12 is a diagram of the hinge apparatus 10 in the open state. In a process in which the user exerts an acting force F1 on the support member 30 to open the hinge apparatus 10, the support member 30 rotates counterclockwise, the first end 110 of the first shaft sleeve assembly 100 rotates clockwise relative to the bearing bracket 400, there is a counterclockwise torque M1 between the first end 110 of the first shaft sleeve assembly 100 and the first shaft core 200, and the bearing bracket 400 exerts an acting force F2 on the first end 110 of the first shaft sleeve assembly 100. F2 has a leftward component force F2_{A} in the first direction A and an upward component force F2c in a third direction C. The second end 120 of the first shaft sleeve assembly 100 rotates clockwise relative to the base 500, there is a counterclockwise torque M2 between the second end 120 of the first shaft sleeve assembly 100 and the second shaft core 300, and the base 500 exerts resistance F3 on the second end 120 of the first shaft sleeve assembly 100. F3 has a rightward component force F3_{A} in the first direction A and a downward component force F3c in the third direction C.

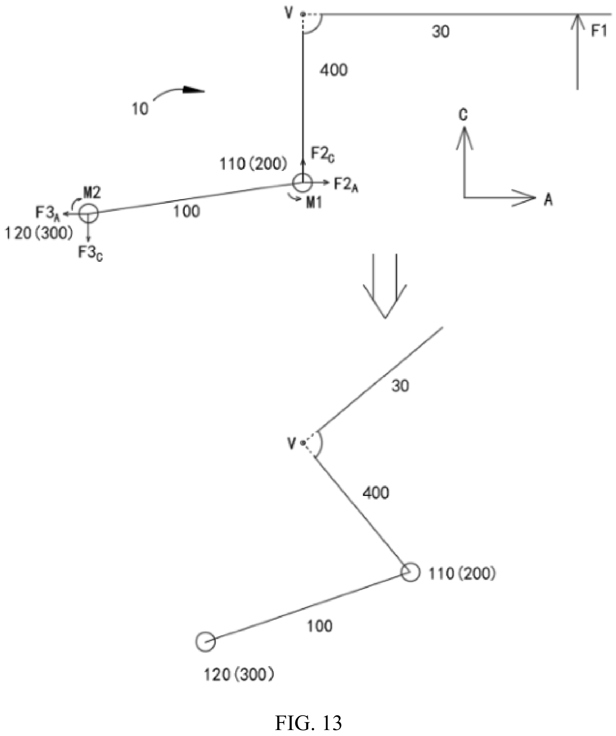

Example 5: FIG. 13 is a diagram of analysis of forces exerted on the first shaft core 200, the second shaft core 300, the virtual central axis V, and the support member 30 according to an embodiment of this application. In an implementation, in the closed state, the first shaft core 200 coincides with the virtual central axis V in a first direction A, and the second shaft core 300 and the virtual central axis V are spaced apart in the first direction A. In this implementation, the second shaft core 300 is located on a left side of the virtual central axis V in the first direction A. For example, as shown in FIG. 13, the second shaft core 300 is located on a left side of the virtual central axis V in the first direction A.

In this implementation, an upper figure in FIG. 13 is a diagram of the hinge apparatus 10 in the closed state, and a lower figure in FIG. 13 is a diagram of the hinge apparatus 10 in the open state. In a process in which the user exerts an acting force F1 on the support member 30 to open the hinge apparatus 10, the support member 30 rotates counterclockwise, the first end 110 of the first shaft sleeve assembly 100 rotates clockwise relative to the bearing bracket 400, there is a counterclockwise torque M1 between the first end 110 of the first shaft sleeve assembly 100 and the first shaft core 200, and the bearing bracket 400 exerts an acting force F2 on the first end 110 of the first shaft sleeve assembly 100. F2 has a rightward component force F2_{A} in the first direction A and an upward component force F2c in a third direction C. The second end 120 of the first shaft sleeve assembly 100 rotates counterclockwise relative to the base 500, there is a clockwise torque M2 between the second end 120 of the first shaft sleeve assembly 100 and the second shaft core 300, and the base 500 exerts resistance F3 on the second end 120 of the first shaft sleeve assembly 100. F3 has a leftward component force F3_{A} in the first direction A and a downward component force F3c in the third direction C.

In the implementations shown in FIG. 8 to FIG. 13, the first shaft core 200 and the second shaft core 300 are disposed on a same side or different sides of the virtual central axis V in the first direction A, so that the hinge apparatus 10 can be used in different application scenarios. This helps improve practicability of the hinge apparatus 10.

It should be noted that FIG. 8 to FIG. 13 are merely examples of performing force analysis on the hinge apparatus 10 and the support member 30, and do not represent specific structures, sizes, and connection relationships of the hinge apparatus 10 and the support member 30. In addition, it may be understood that upward, downward, leftward, rightward, clockwise, and counterclockwise in embodiments of this application are merely relative concepts. In different observation angles or mounting manners, the first shaft core 200, the second shaft core 300, and the virtual central axis V present different location relationships, and the components in the hinge apparatus 10 present different rotation directions in a movement process. A person skilled in the art may make a judgment based on an actual situation. This is not absolutely limited in this application.

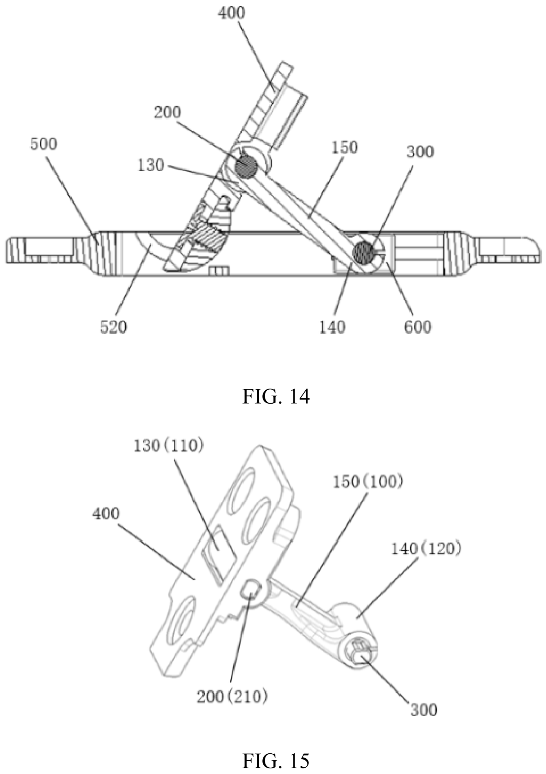

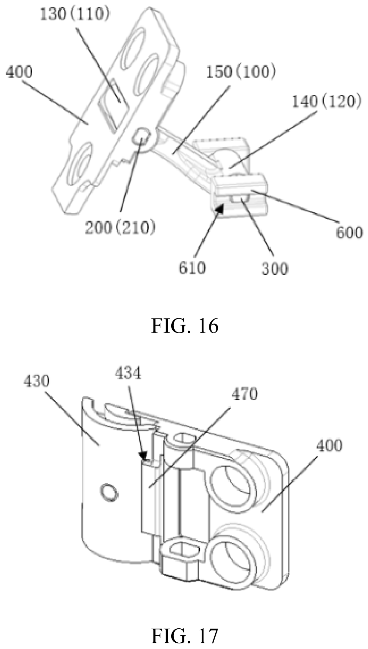

Return to the first embodiment of this application. The following describes a possible implementation of the first shaft sleeve assembly 100 according to the first embodiment of this application. Refer to FIG. 14 to FIG. 16. FIG. 14 is a sectional view of the hinge apparatus 10 shown in FIG. 5 according to the first embodiment. FIG. 15 is a diagram of a partial structure of the hinge apparatus 10 shown in FIG. 5 according to the first embodiment. FIG. 16 is a diagram of a partial structure of the hinge apparatus 10 shown in FIG. 5 according to the first embodiment. In an implementation, the first shaft sleeve assembly 100 includes a first shaft sleeve 130 and a second shaft sleeve 140 (as shown in FIG. 14) that are fastened to each other. The first shaft sleeve 130 is sleeved on the first shaft core 200, is capable of rotating relative to the first shaft core 200, and is in interference fit with the first shaft core 200, and the second shaft sleeve 140 is sleeved on the second shaft core 300, is capable of rotating relative to the second shaft core 300, and is in interference fit with the second shaft core 300.

In this implementation, the first shaft sleeve 130 is fastened to the second shaft sleeve 140. During opening and closing of the hinge apparatus 10, the first shaft sleeve 130 and the second shaft sleeve 140 can keep moving or stationary synchronously. This helps ensure smooth movement of the first shaft sleeve assembly 100, and further improve stability of the hinge apparatus 10 when the hinge apparatus 10 supports the electronic device 1. The first shaft sleeve 130 is in interference fit with the first shaft core 200, so that a torque can be generated in a process in which the first shaft sleeve 130 rotates relative to the first shaft core 200. A similar principle applies to the second shaft sleeve 140 and the second shaft core 300. The first shaft sleeve 130 and the second shaft sleeve 140 each can provide a torque in the hinge apparatus 10. This helps increase a total torque provided by the hinge apparatus 10 during opening and closing, so that the hinge apparatus 10 can stably support the electronic device 1 at an angle set by a user.

Refer to FIG. 7 and FIG. 14. In an implementation, the first shaft sleeve assembly 100 further includes a first connecting rod 150 (as shown in FIG. 14). The first connecting rod 150 is connected between the first shaft sleeve 130 and the second shaft sleeve 140, and an extension direction of the first connecting rod 150 is perpendicular to an axial direction of the first shaft sleeve 130. In this implementation, the first shaft sleeve 130 is fastened to the second shaft sleeve 140 via the first connecting rod 150, and the first connecting rod 150 is configured to transmit power from the first shaft sleeve 130 to the second shaft sleeve 140, so that the first shaft sleeve assembly 100 rotates as a whole. In an implementation, the first shaft sleeve 130, the first connecting rod 150, and the second shaft sleeve 140 are integrally formed. According to this implementation, stability of an overall structure of the first shaft sleeve assembly 100 can be improved.

In an implementation, the bearing bracket 400 includes an avoidance hole 410 (as shown in FIG. 7). The avoidance hole 410 penetrates the bearing bracket 400, and a part of the first shaft sleeve 130 is located in the avoidance hole 410. According to this solution, a volume of the hinge apparatus 10 can be reduced, to help implement a miniaturization design.

In an implementation, the bearing bracket 400 further includes first shaft core mounting holes 420 (as shown in FIG. 7). The first shaft core mounting holes 420 are located at two ends of the bearing bracket 400 in a second direction B. The first shaft core 200 includes a first end 210 and a second end 220 (as shown in FIG. 7) that are disposed opposite to each other. Both the first end 210 and the second end 220 of the first shaft core 200 are in flat fit with the first shaft core mounting holes 420 to keep relative fastening. In this implementation, the second direction B is a width direction of the hinge apparatus 10. A part between the first end 210 of the first shaft core 200 and the second end 220 of the first shaft core 200 is in interference fit with the first shaft sleeve 130, and the first end 210 and the second end 220 of the first shaft core 200 are in flat fit with the first shaft core mounting holes 420 to keep relative fastening.

The first end 210 of the first shaft core 200 is used as an example. Flat fit means that flat locations are respectively provided on an outer wall of the first end 210 of the first shaft core 200 and an inner wall of the first shaft core mounting hole 420 and are opposite to each other. The flat locations are in contact with each other, so that no relative movement occurs between the first end 210 of the first shaft core 200 and the first shaft core mounting hole 420. Specifically, the first shaft core mounting hole 420 is in a racetrack shape and has two oppositely disposed planes on an inner surface, and there are two oppositely disposed planes on outer circumferential surfaces of the first end 210 and the second end 220 of the first shaft core 200. When the first end 210 and the second end 220 of the first shaft core 200 are located in the first shaft core mounting holes 420, planes of the outer circumferential surfaces of the first end 210 and the second end 220 are attached to planes of inner surfaces of the first shaft core mounting holes 420, so that both the first end 210 and the second end 220 of the first shaft core 200 are in flat fit with the first shaft core mounting holes 420.

In an implementation, a manner in which the first end 210 and the second end of the first shaft core 200 are fastened to the first shaft core mounting holes 420 is not limited to flat fit. For example, the manner may alternatively be concave-convex fit. To be specific, a protrusion is provided at the first end 210 of the first shaft core 200, a groove is provided in the first axial mounting hole, and the protrusion fits the groove, to implement fastening between the first end 210 of the first shaft core 200 and the first shaft core mounting hole 420.

The following describes other possible implementations of the first shaft sleeve 130 and the second shaft sleeve 140 according to the first embodiment of this application.

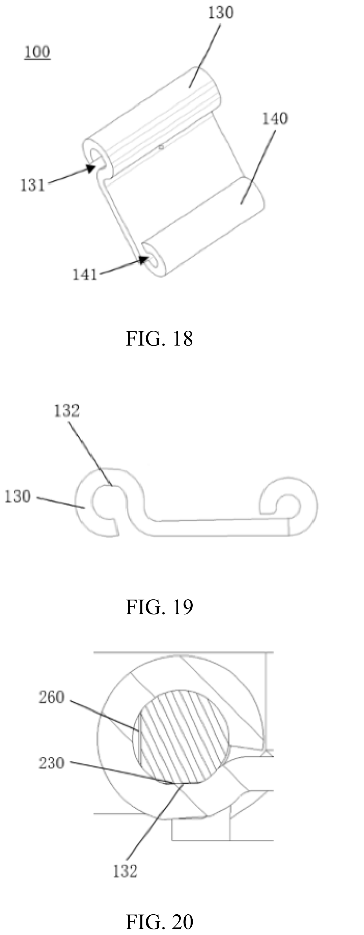

Example 1: Refer to FIG. 7 and FIG. 18. FIG. 18 is a diagram of a structure of the first shaft sleeve 130 and the second shaft sleeve 140 in the hinge apparatus 10 according to the first embodiment of this application. In an implementation, the first shaft sleeve 130 is provided with a first opening 131 (as shown in FIG. 7 and FIG. 18) that penetrates an inner surface and an outer surface of the first shaft sleeve 130, and the first opening 131 extends in an axial direction of the first shaft sleeve 130 (as shown in FIG. 7). In this implementation, the first shaft sleeve 130 is not in a closed cylindrical shape. Because the first shaft sleeve 130 is in interference fit with the first shaft core 200, the first shaft sleeve 130 is subject to specific resistance when rotating relative to the first shaft core 200. In this solution, the first opening 131 is disposed in the first shaft sleeve 130, so that a rotation amplitude of the first shaft sleeve 130 relative to the first shaft core 200 can be increased. In addition, the first opening 131 can be further used to increase elasticity of the first shaft sleeve 130.

In an implementation, the second shaft sleeve 140 is provided with a second opening 141 (as shown in FIG. 7 and FIG. 18) that penetrates an inner surface and an outer surface of the second shaft sleeve 140, and the second opening 141 extends in an axial direction of the second shaft sleeve 140. When the first shaft sleeve 130 is provided with the first opening 131 and the second shaft sleeve 140 is provided with the second opening 141, the first opening 131 and the second opening 141 may be opened in different directions. In this implementation, the second shaft sleeve 140 is not in a closed cylindrical shape. Because the second shaft sleeve 140 is in interference fit with the second shaft core 300, the second shaft sleeve 140 is subject to specific resistance when rotating relative to the second shaft core 300. In this solution, the second opening 141 is disposed in the second shaft sleeve 140, so that a rotation amplitude of the second shaft sleeve 140 relative to the second shaft core 300 can be increased.

Example 2: Refer to FIG. 19 and FIG. 20. FIG. 19 is a diagram of a structure of the first shaft sleeve 130 and the first shaft core 200 in the hinge apparatus 10 according to the first embodiment of this application. FIG. 20 is a diagram of a partial structure of the hinge apparatus 10 according to the first embodiment of this application. In an implementation, a first shaft sleeve plane part 132 (as shown in FIG. 19) is provided on an inner surface of the first shaft sleeve 130, and a first shaft core plane part 230 (as shown in FIG. 20) parallel to the first shaft sleeve plane part 132 is provided on an outer surface of the first shaft core 200. In the closed state, the first shaft sleeve plane part 132 and the first shaft core plane part 230 are disposed opposite to each other (as shown in FIG. 20).

In this implementation, the first shaft sleeve plane part 132 fits the first shaft core plane part 230, and in the closed state, both the first shaft sleeve plane part 132 and the first shaft core plane part 230 are parallel to the bottom of the base 500. When the hinge apparatus 10 is in the closed state, the first shaft sleeve 130 and the first shaft core 200 need to be kept from rotating relative to each other. Therefore, in this solution, the first shaft sleeve plane part 132 and the first shaft core plane part 230 are disposed, so that the first shaft sleeve 130 and the first shaft core 200 can be limited in a circumferential direction. Further, the hinge apparatus 10 is locked in the closed state. It may be understood that locking the hinge apparatus 10 is only a temporary state. When the hinge apparatus 10 needs to change from the closed state to the open state, only an acting force needs to be exerted on the hinge apparatus 10, and the first shaft sleeve plane part 132 is separated from the first shaft core plane part 230.

Still refer to FIG. 20. In an implementation, an open-lock plane part 260 is further disposed on the outer surface of the first shaft core 200. In the closed state, the open-lock plane part 260 is spaced from the first shaft core plane part 230. In a process in which the hinge apparatus 10 switches from the closed state to the open state, when the first shaft sleeve plane part 132 rotates to be disposed opposite to and parallel to the open-lock plane part 260, the hinge apparatus 10 is locked and maintained at an opening angle, so that the hinge apparatus 10 can be stably maintained in the open state.

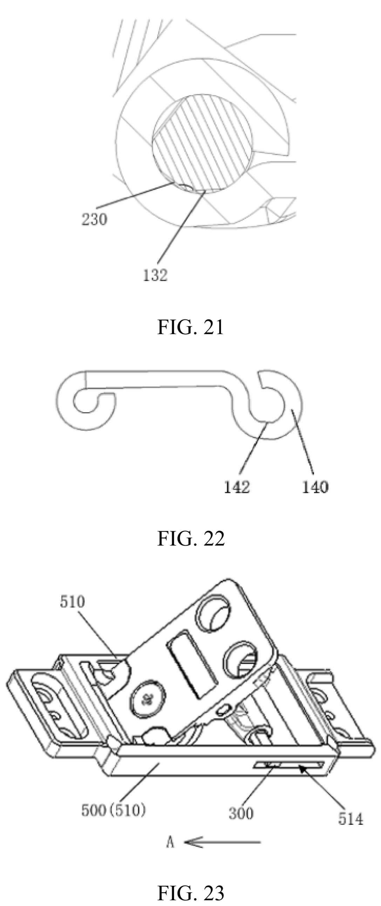

Example 3: FIG. 21 is a diagram of a partial structure of the first shaft sleeve 130 and the first shaft core 200 in the hinge apparatus 10 according to the first embodiment of this application. In an implementation, in the closed state, there is an included angle between the first shaft sleeve plane part 132 and the first shaft core plane part 230. In a process in which the hinge apparatus 10 switches from the closed state to the open state, when the first shaft sleeve plane part 132 rotates to be parallel to the first shaft core plane part 230, the hinge apparatus 10 is locked and maintained at the opening angle, so that the hinge apparatus 10 can be stably maintained in the open state. According to this solution, the hinge apparatus 10 can be locked at a specific angle in a process of opening the hinge apparatus 10, so that the hinge apparatus 10 can meet use requirements in different scenarios.

Refer to FIG. 20 to FIG. 22. FIG. 22 is a diagram of a structure of the second shaft sleeve 140 in the hinge apparatus 10 according to the first embodiment of this application. In an implementation, a second shaft sleeve plane part 142 is provided on an inner surface of the second shaft sleeve 140 (as shown in FIG. 22), and a second shaft core plane part (not shown in the figure) parallel to the second shaft sleeve plane part 142 is provided on an outer surface of the second shaft core 300. In the closed state, the second shaft sleeve plane part 142 and the second shaft core plane part are disposed opposite to each other. In another implementation, in the closed state, there is a third included angle between the second shaft sleeve plane part 142 and the second shaft core plane part. For specific descriptions of locking the hinge apparatus 10 by the second shaft sleeve plane part 142 and the second shaft core plane part at different angles, refer to related content of the first shaft sleeve plane part 132 and the first shaft core plane part 230. Details are not described herein again.

In an implementation, the first shaft sleeve 130, the first connecting rod 150, and the second shaft sleeve 140 are sheet metal parts or metal injection molded parts. Sheet metal is a comprehensive cold machining technique for a metal sheet. The sheet metal machining technique enables machining procedures of the first shaft sleeve 130, the first connecting rod 150, and the second shaft sleeve 140 to be simple, and facilitates large-scale production. Metal injection molding (Metal Injection Molding, MIM) is a precision manufacturing process in which a mixture of metal powder and plastic or wax is injected into a metal mold and molded under a high temperature and high pressure. An MIM technology has advantages such as high efficiency, low costs, and high precision. The first shaft sleeve 130, the first connecting rod 150, and the second shaft sleeve 140 can be quickly and accurately manufactured by using the MIM technology.

Continue to return to the first embodiment of this application. The following describes a possible implementation of the second shaft core 300 and the base 500 according to the first embodiment of this application. In an implementation, the second shaft core 300 is in interference fit with the base 500, so that a torque is generated in a process in which the second shaft core 300 and the base 500 slide relative to each other. In an implementation, the second shaft core 300 may be in indirect contact (as shown in FIG. 5) or in direct contact (as shown in FIG. 23) with and in interference fit with the base 500, so that in a sliding process of the second shaft core 300, a friction force between the second shaft core 300 and the base 500 can be used to increase a total torque provided by the hinge apparatus 10, to help ensure that the hinge apparatus 10 is stably maintained at a specific angle.

Still refer to FIG. 5 to FIG. 7. In an implementation, the second shaft core 300 slides relative to the base 500 in the first direction A, and the first direction A intersects an axis of the second shaft core 300. In this implementation, the first direction A is a length direction of the hinge apparatus 10, and the second shaft core 300 slides in the first direction A. This can effectively use a size of the hinge apparatus 10 in the length direction, thereby helping reduce a volume of the hinge apparatus 10.

In an implementation, the second shaft core 300 slides relative to the base 500 in a fourth direction (not shown in the figure), and the fourth direction is straight with a component in the first direction A.

In an implementation, the second shaft core 300 slides relative to the base 500 in an arc direction (not shown in the figure), and the arc direction has a component in the first direction A.

Still refer to FIG. 5, FIG. 7, and FIG. 16. In an implementation, the hinge apparatus 10 further includes two sliding blocks 600 (as shown in FIG. 7 and FIG. 16), where the two sliding blocks 600 are respectively fastened to two ends of the second shaft core 300 in the second direction B (as shown in FIG. 16). The base 500 includes two support plates 510 (as shown in FIG. 7) that are arranged in the second direction B and are spaced apart, and the two sliding blocks 600 and the second shaft core 300 are located between the two support plates 510 in the second direction B (as shown in FIG. 5). The sliding block 600 and the support plate 510 that are disposed on a same side in the second direction B are slidably connected and can slide relative to each other, and the second direction B is parallel to the axis of the second shaft core 300.

In this implementation, the second shaft core 300 is slidably connected to the base 500 via the two sliding blocks 600. The two sliding blocks 600 are respectively denoted as a sliding block 600a and a sliding block 600b, and the two support plates 510 are respectively denoted as a first support plate 510a and a second support plate 510b. Two opposite ends of the sliding block 600a and the sliding block 600b in the second direction B are fastened to two ends of the second shaft core 300 in the second direction B, two ends that are of the sliding block 600a and the sliding block 600b and that are back to each other in the second direction B can be respectively slidably connected to the first support plate 510a and the second support plate 510b. In this way, the sliding block 600a, the second shaft core 300, and the sliding block 600b can slide relative to the first support plate 510a and the second support plate 510b. In this implementation, the second shaft core 300 is further in interference fit with the second shaft sleeve 140, and the second shaft sleeve 140 may transmit power to the second shaft core 300, to drive the second shaft core 300 to slide relative to the base 500.

In an implementation, the base 500 may include four support plates 510. Two of the support plates 510 are arranged in the second direction B and spaced apart, the other two of the support plates 510 are arranged in the first direction A and spaced apart, and the four support plates 510 are enclosed to form a frame body (as shown in FIG. 7).

In an implementation, device mounting holes 516 are provided on the two support plates 510 arranged in the first direction A, and the base 500 is fastened to the device body via the device mounting holes 516.

Still refer to FIG. 7 and FIG. 16. In an implementation, in the sliding block 600 and the support plate 510 that are disposed on the same side in the second direction B, a protrusion 511

(as shown in FIG. 7) is provided on a side that is of the support plate 510 and that faces the sliding block 600 in the second direction B, a first groove 610 (as shown in FIG. 7 and FIG. 16) is provided on a side that is of the sliding block 600 and that faces the support plate 510, the protrusion 511 is located in the first groove 610, and the protrusion 511 and the first groove 610 can slide relative to each other.

In this implementation, a protruding direction of the protrusion 511 is the same as a concave direction of the first groove 610, a shape of the protrusion 511 fits a shape of the first groove 610, and the sliding block 600 and the support plate 510 fit each other via the first groove 610 and the protrusion 511, so that the sliding block 600 and the support plate 510 are slidably connected. According to this solution, a sliding connection is implemented through concave-convex fit, and a structure is simple and easy to machine.

In this implementation, extension directions of the protrusion 511 and the first groove 610 are parallel to the first direction A, so that the second shaft core 300 slides relative to the base 500 in the first direction A.

In an implementation, the protrusion 511 is in interference fit with a groove wall of the first groove 610. In this implementation, that the protrusion 511 is in interference fit with the first groove 610 means that the protrusion 511 and the first groove 610 are subject to specific friction resistance when sliding relative to each other. This can increase a torque, thereby improving stability of the hinge apparatus 10. In this implementation, the second shaft core 300 and the base 500 are in indirect contact and in interference fit with each other through the interference fit between the protrusion 511 and the groove wall of the first groove 610.

In an implementation, a thickness of the protrusion 511 is set to be greater than a groove width of the first groove 610, and the protrusion 511 is squeezed into the first groove 610, so that the protrusion 511 is in interference fit with the groove wall of the first groove 610 to generate a torque.

The following describes another possible implementation of the second shaft core 300 and the base 500 according to the first embodiment of this application. Refer to FIG. 23. FIG. 23 is a diagram of a structure of the hinge apparatus 10 according to an embodiment of this application. In an implementation, the base 500 includes two support plates 510 that are spaced apart in the second direction B, the two support plates 510 each are provided with a base sliding groove 514, two ends of the second shaft core 300 in the second direction B penetrate the base sliding groove 514, and the base sliding grooves 514 extend in the first direction A. The second shaft core 300 slides in the base sliding grooves 514 in the first direction A, so that the first shaft sleeve assembly 100 slides relative to the base 500 in the first direction A.

In this implementation, the base sliding grooves 514 penetrate two end faces of the support plates 510 in the second direction B, and the base sliding grooves 514 extend in the first direction A, so that one end of the second shaft core 300 located in the base sliding grooves 514 can slide in the first direction A. Because the first direction A is the length direction of the hinge apparatus 10, the size of the hinge apparatus 10 in the length direction can be effectively used by disposing the second shaft core 300 to slide in the first direction A. The second shaft core 300 is in interference fit with the other end of the first shaft sleeve assembly 100, and the second shaft core 300 can slide relative to the base 500 in the first direction A, so that the first shaft sleeve assembly 100 can slide in the first direction A.

In an implementation, the second shaft core 300 is in interference fit with inner walls of the base sliding grooves 514. In this implementation, a friction force between the second shaft core 300 and the base sliding grooves 514 can be used to increase a total torque provided by the hinge apparatus 10, thereby improving stability of the hinge apparatus 10. In this implementation, the second shaft core 300 and the base 500 are in direct contact and in interference fit with each other through the interference fit between the second shaft core 300 and the inner walls of the base sliding grooves 514.

The following describes a possible implementation of the bearing bracket 400 and the base 500 according to the first embodiment of this application. Still refer to FIG. 7. In an implementation, the bearing bracket 400 and the base 500 are in interference fit with each other, so that a torque is generated in a process in which the bearing bracket 400 and the base 500 rotate relative to each other. In this implementation, the bearing bracket 400 and the base 500 can rotate relative to each other, and the bearing bracket 400 and the base 500 are in interference fit with each other, so that a specific torque can be provided by using a friction force generated when the bearing bracket 400 rotates relative to the base 500, and a total torque provided by the hinge apparatus 10 is increased without increasing a volume of the hinge apparatus 10. This improves stability of the hinge apparatus 10 when the hinge apparatus 10 supports the electronic device 1.

Still refer to FIG. 7. In an implementation, the base 500 includes two support plates 510 that are arranged in the second direction B and are spaced apart, and an end of the bearing bracket 400 is located between the two support plates 510, two sides of the end of the bearing bracket 400 is rotatably connected to the two support plates 510 in the second direction B, and the second direction B is parallel to the first shaft core 200. In this implementation, the end of the bearing bracket 400 in the first direction A is located between the two support plates 510. The end of the bearing bracket 400 in the first direction A is rotatably connected to the two support plates 510, so that the bearing bracket 400 can rotate relative to the base 500.

In an implementation, the two support plates 510 of the base 500 are separately in interference fit with the bearing bracket 400. In this implementation, the support plates 510 are in interference fit with the bearing bracket 400, so that a friction force generated when the bearing bracket 400 rotates relative to the support plates 510 can be used to increase the total torque provided by the hinge apparatus 10.

Still refer to FIG. 7. In an embodiment, the hinge apparatus 10 further includes a first rotating member 430 and a second rotating member 520, where the first rotating member 430 is fastened to the bearing bracket 400, the second rotating member 520 is fastened to the base 500, and the bearing bracket 400 is rotatably connected to the base 500 through fit between the first rotating member 430 and the second rotating member 520.

In this implementation, the first rotating member 430 is located on a side that is of the bearing bracket 400 and that faces the support plate 510, and the second rotating member 520 is located on an inner side of the support plate 510. The bearing bracket 400 rotates relative to the base 500, to drive the first rotating member 430 to rotate relative to the second rotating member 520.

In an implementation, an avoidance groove 435 is provided on a surface that is of the first rotating member 430 and that faces the bearing bracket 400, an end of the bearing bracket 400 is located in the avoidance groove 435, and the bearing bracket 400 is fastened to the bottom of the avoidance groove 435 via a screw.

In an implementation, each of two ends of the first rotating member 430 in the second direction B includes a sliding groove 436, the second rotating member 520 is a slide protrusion 523, a shape of the sliding groove 436 fits a shape of the slide protrusion 523, and the first rotating member 430 fits the second rotating member 520, so that the bearing bracket 400 is rotatably connected to the base 500.

In an implementation, the first rotating member 430 and the bearing bracket 400 are integrally formed, and the second rotating member 520 and the base 500 are integrally formed. In this implementation, stability of a rotatable connection between the bearing bracket 400 and the base 500 can be improved.

In an implementation, the second rotating member 520 further includes a stop portion 521 protruding toward the first rotating member 430, and the stop portion 521 is located at an end of the second rotating member 520 in the first direction A. When the first rotating member 430 rotates relative to the second rotating member 520 to the stop portion 521, the first rotating member 430 stops rotating.

Still refer to FIG. 7. In an implementation, the first rotating member 430 and the second rotating member 520 are in interference fit with each other. In this implementation, a torque can be provided by using a friction force generated in a process in which the first rotating member 430 and the second rotating member 520 rotate relative to each other, so that a total torque of the hinge apparatus 10 is increased without increasing a volume of the hinge apparatus 10. In this implementation, the bearing bracket 400 is in interference fit with the base 500 through the interference fit between the first rotating member 430 and the second rotating member 520.

Refer to FIG. 17. FIG. 17 is a diagram of a partial structure of the hinge apparatus 10 shown in FIG. 5 according to the first embodiment. In an implementation, a clamping groove 434 is provided on a surface that is of the first rotating member 430 and that is away from the bearing bracket 400, a buckle 470 is provided on a surface that is of the bearing bracket 400 and that faces the base 500, and the buckle 470 is clamped in the clamping groove 434, so that the first rotating member 430 and the bearing bracket 400 are fastened relative to each other. In this implementation, stability of a connection between the first rotating member 430 and the bearing bracket 400 is further improved by using the buckle 470 and the clamping groove 434.

The following describes an assembly method and total torque analysis of the hinge apparatus 10 according to the first embodiment of this application. Still refer to FIG. 5 and FIG. 7. In a process of assembling the hinge apparatus 10 shown in FIG. 5, the second shaft core 300 is inserted into the second shaft sleeve 140 of the first shaft sleeve assembly 100, then, the first shaft sleeve 130 of the first shaft sleeve assembly 100 is placed in the avoidance hole 410 of the bearing bracket 400, and the first end 210 of the first shaft core 200 and the second end 220 of the first shaft core 200 are inserted into the first shaft core mounting hole 420 of the bearing bracket 400 and the first shaft sleeve 130 of the first shaft sleeve assembly 100, to form the partial structure shown in FIG. 15. Two ends of the second shaft core 300 are respectively inserted into through holes 620 of the two sliding blocks 600, to form the partial structure shown in FIG. 16. Then, the bearing bracket 400 is fastened to the first rotating member 430 via a screw, and the buckle 470 of the bearing bracket 400 is clamped in the clamping groove 434 of the first rotating member 430, as shown in FIG. 17. Finally, the first groove 610 of the sliding block 600 slides into the protrusion from an end that is of the protrusion 511 and that is close to the second rotating member 520 in the first direction A, the first rotating member 430 slides into the second rotating member 520 from an end that is of the second rotating member 520 and that is away from the protrusion 511 in the first direction A. In this way, the hinge apparatus 10 finally presents the structure shown in FIG. 5. In the hinge apparatus 10 shown in FIG. 5, the base 500 is integrally formed, so that structural strength of the hinge apparatus 10 can be improved, and a welding process can be reduced. In addition, the hinge apparatus 10 has a disassembly and assembly manner of disassembling components from top to bottom, which helps reduce operation difficulty and costs of assembly and rework.

Still refer to FIG. 5. In an implementation, Mₜₒₜₐₗ=k₁×M₁+k₂×M₂+k₃×M₃+k₄×M₄. Herein, Mₜₒₜₐₗ is the total torque in the embodiment shown in FIG. 5, M₁ is generated at a location at which the first shaft core 200 is in interference fit with the first shaft sleeve 130, M₂ is generated at a location at which the second shaft core 300 is in interference fit with the second shaft sleeve 140, M₃ is generated at a location at which the bearing bracket 400 is rotatably connected to the base 500, a torque M₄ is generated at a location at which the sliding block 600 is slidably connected to the base 500, and k₁ to k₄ are contribution coefficients of the locations at which the torques are generated to the total torque. The contribution coefficients are related to a structure layout and a size of the hinge apparatus. For details, refer to related descriptions in FIG. 8. The torques are generated at the foregoing four locations, so that the overall torque Mₜₒₜₐₗ of the hinge apparatus 10 can be increased. In this way, the hinge apparatus 10 can support a larger electronic device or support the electronic device at a large angle. Alternatively, when the supported electronic device is determined, a volume of the hinge apparatus 10 may be reduced, which helps implement a light and thin design of the entire electronic device.

In some implementations, interference fit may be set at some locations to generate torques. For example, Mₜₒₜₐₗ=k₁×M₁+k₂×M₂+k₃×M₃. For example, Mₜₒₜₐₗ=k₁×M₁+k₂×M₂+k₄×M₄.

The following describes a possible implementation of the hinge apparatus 10 according to a second embodiment of this application.

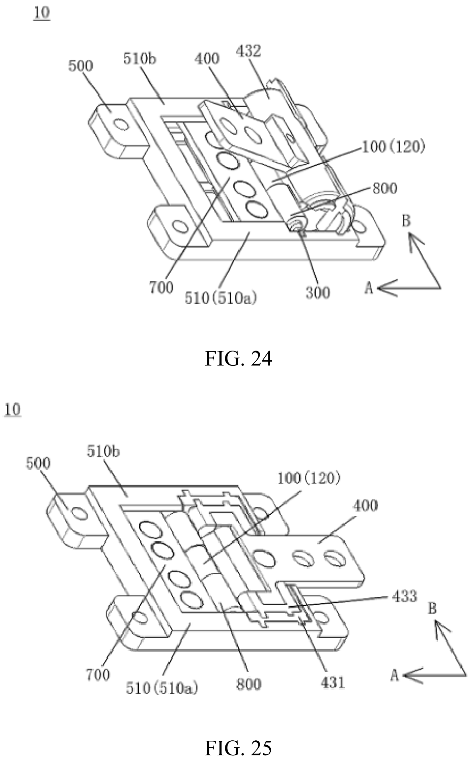

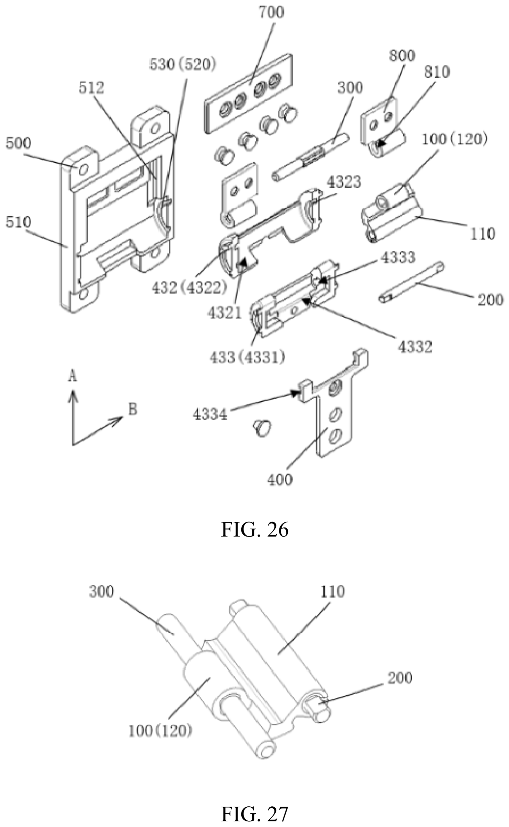

Refer to FIG. 24 to FIG. 26. FIG. 24 is a diagram of a structure of the hinge apparatus 10 in an open state according to the second embodiment of this application. FIG. 25 is a diagram of a structure of the hinge apparatus 10 shown in FIG. 24 in a closed state according to the second embodiment. FIG. 26 is an exploded view of the hinge apparatus 10 shown in FIG. 24 according to the second embodiment.

In an implementation, the hinge apparatus 10 has an open state and a closed state, and the hinge apparatus 10 includes a base 500, a bearing bracket 400, a first shaft core 200, a second shaft core 300, and a first shaft sleeve assembly 100 (as shown in FIG. 26). The bearing bracket 400 is rotatably connected to the base 500, for the bearing bracket 400 to be opened or closed relative to the base 500 (with reference to FIG. 24 and FIG. 25). The first shaft core 200 is fastened to the bearing bracket 400 (with reference to FIG. 24 to FIG. 26). The second shaft core 300 is slidably connected to the base 500 (with reference to FIG. 24 to FIG. 26). A first end 110 of the first shaft sleeve assembly 100 is sleeved on the first shaft core 200 and is capable of rotating relative to the first shaft core 200 (with reference to FIG. 24 to FIG. 26), a second end 120 of the first shaft sleeve assembly 100 is sleeved on the second shaft core 300 and is capable of rotating relative to the second shaft core 300 (with reference to FIG. 24 to FIG. 26), and the two ends of the first shaft sleeve assembly 100 are respectively in interference fit with the first shaft core 200 and the second shaft core 300, to enable the first shaft sleeve assembly 100 and each of the first shaft core 200 and the second shaft core 300 to be configured to provide a torque for the hinge apparatus 10 in a process in which the hinge apparatus 10 switches between the open state and the closed state.

In an implementation, Mₜₒₜₐₗ=k₁×M₁+k₂×M₂. Herein, Mₜₒₜₐₗ is a total torque in the embodiment shown in FIG. 24, M₁ is generated at a location at which the first shaft core 200 is in interference fit with the first end 110 of the first shaft sleeve assembly 100, and M₂ is generated at a location at which the second shaft core 300 is in interference fit with the second end 120 of the first shaft sleeve assembly 100. The torques are generated at the foregoing two locations, so that the overall torque Mₜₒₜₐₗ of the hinge apparatus 10 can be increased. In this way, the hinge apparatus 10 can support a larger electronic device or support the electronic device at a large angle. Alternatively, when the supported electronic device is determined, a volume of the hinge apparatus 10 may be reduced, which helps implement a light and thin design of the entire electronic device. For specific analysis of beneficial effect brought by interference fit between the two ends of the first shaft sleeve assembly 100, and the first shaft core 200 and the second shaft core 300, refer to the first embodiment. Details are not described herein again.

It should be noted that Example 1, Example 2, and Example 3 of the first shaft sleeve 130 and the second shaft sleeve 140 in the first embodiment are also applicable to the possible implementation of the first shaft sleeve 130 and the second shaft sleeve 140 in the second embodiment.

The following describes a possible implementation of the second shaft core 300 and the base 500 according to the second embodiment of this application. Still refer to FIG. 24 to FIG. 26. Different from that in the first embodiment, in the second embodiment, the hinge apparatus 10 further includes a sliding plate 700 and a shaft core fastener 800 that are fastened to each other (as shown in FIG. 24 to FIG. 26). The base 500 includes two support plates 510 that are arranged in a second direction B and are spaced apart, and a second groove 512 (as shown in FIG. 26) is provided on an inner side wall of each support plate 510, and two ends of the sliding plate 700 in the second direction B are located in the second grooves 512 and are capable of sliding relative to the second grooves 512 (with reference to FIG. 24 to FIG. 26). Apart of the second shaft core 300 is fastened to the shaft core fastener 800 (with reference to FIG. 24 and FIG. 26), and a part of the second shaft core 300 is rotatably connected to the second end 120 of the first shaft sleeve assembly 100.

In this implementation, the second grooves 512 of the two support plates 510 are disposed opposite to each other, the sliding plate 700 is located between the two second grooves 512, and two ends of the sliding plate 700 slide in the second grooves 512 in an extension direction of the second grooves 512. The part of the second shaft core 300 is fastened to the shaft core fastener 800, and the part of the second shaft core 300 is rotatably connected to the second end 120 of the first shaft sleeve assembly 100. In other words, the second shaft core 300 is fastened relative to the shaft core fastener 800, the second end 120 of the first shaft sleeve assembly 100 can rotate relative to the second shaft core 300. The first end 110 of the first shaft sleeve assembly 100 is sleeved on the first shaft core 200 and is capable of rotating relative to the first shaft core 200. The hinge apparatus 10 in this implementation has a compact structure, which helps reduce a volume of the hinge apparatus 10.

In an implementation, the sliding plate 700 is in interference fit with the second grooves 512 of the support plates 510. According to this solution, a friction force generated when the sliding plate 700 slides in the second grooves 512 can be used to increase the total torque provided by the hinge apparatus 10. In this implementation, the second shaft core 300 and the base 500 are in indirect contact and in interference fit with each other through the interference fit between the sliding plate 700 and the second grooves 512 of the support plates 510.

In an implementation, the part of the second shaft core 300 is in interference fit with the second end 120 of the first shaft sleeve assembly 100. According to this solution, a friction force generated when the second end 120 of the first shaft sleeve assembly 100 rotates relative to the part of the second shaft core 300 can be used to increase the total torque provided by the hinge apparatus 10.

In an implementation, the second groove 512 extends in the first direction A (as shown in FIG. 26), so that the sliding plate 700 can slide relative to the base 500 in the first direction A.

In an implementation, the second groove 512 extends in a fourth direction (not shown in the figure), and the fourth direction is straight with a component in the first direction A.

In an implementation, the second groove 512 extends in an arc direction (not shown in the figure), and the arc direction has a component in the first direction A.

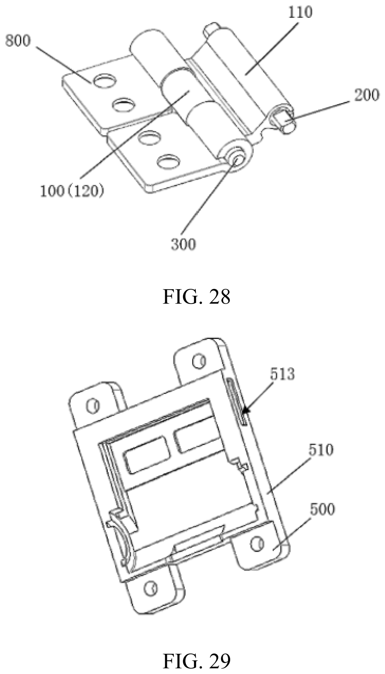

Refer to FIG. 26, FIG. 27, and FIG. 28. FIG. 27 is a diagram of a partial structure of the hinge apparatus 10 according to the second embodiment shown in FIG. 24. FIG. 28 is a diagram of a partial structure of the hinge apparatus 10 according to the second embodiment shown in FIG. 24. In an implementation, the hinge apparatus 10 includes two shaft core fasteners 800 (as shown in FIG. 28), the two shaft core fasteners 800 are spaced from each other and fastened to the sliding plate 700 in the second direction B (as shown in FIG. 26), the second shaft core 300 penetrates fastening holes 810 of the two shaft core fasteners 800 and is fastened relative to the fastening holes 810 (with reference to FIG. 26 and FIG. 28), and the second end 120 of the first shaft sleeve assembly 100 is sleeved on the middle of the second shaft core 300 and located between the two shaft core fasteners 800 (with reference to FIG. 26 and FIG. 27).

In this implementation, the two shaft core fasteners 800 are fastened to the sliding plate 700. When the sliding plate 700 slides in the second grooves 512 of the support plates 510, the sliding plate 700 drives the shaft core fastener 800 to slide relative to the base 500 in the extension direction of the second grooves 512. Two ends of the second shaft core 300 in the second direction B are respectively located in the fastening holes 810 of the two shaft core fasteners 800, and a part between the two ends of the second shaft core 300 is rotatably connected to the first end 110 of the first shaft sleeve assembly 100. In some implementations, the hinge apparatus 10 may have only one shaft core fastener 800, two fastening holes 810 are spaced apart at an end of the shaft core fastener 800, and the two fastening holes 810 are respectively configured to implement fastening fit with the two ends of the second shaft core 300.

Refer to FIG. 26 and FIG. 29. FIG. 29 is a diagram of a partial structure of the hinge apparatus 10 according to the second embodiment shown in FIG. 24. In an implementation, one support plate 510 of the base 500 is provided with a sliding plate assembly hole 513 (as shown in FIG. 29), the sliding plate 700 is mounted into the base 500 via the sliding plate assembly hole 513 and slides into the second groove 512 of the support plate 510 (with reference to FIG. 26 and FIG. 29), and orthographic projections of the second groove 512 and the sliding plate assembly hole 513 in the second direction B overlap at most. In this implementation, a mounting operation of the sliding plate 700 can be simplified.

The following describes a possible implementation of the bearing bracket 400 and the base 500 according to the second embodiment of this application. Still refer to FIG. 26. The bearing bracket 400 and the base 500 are rotatably connected via the first rotating member 430 and the second rotating member 520. In an implementation, the first rotating member 430 includes a first guide rail block 432 and a second guide rail block 433, and the first guide rail block 432 includes a first accommodation groove 4321 away from an opening at the bottom of the base 500. The second guide rail block 433 is located in the first accommodation groove 4321 and can rotate relative to the first guide rail block 432, the first guide rail block 432 is rotatably connected to the base 500, and the second guide rail block 433 is fastened to the bearing bracket 400.

In this implementation, outer walls of two ends of the second guide rail block 433 in the second direction B can rotate relative to an inner wall of the first accommodation groove 4321 of the first guide rail block 432 in the second direction B, and outer walls of two ends of the first guide rail block 432 in the second direction B can rotate relative to an inner wall of the base 500 in the second direction B. In other words, the second guide rail block 433 can rotate relative to the base 500 for two stages. This helps increase an opening/closing angle of the second guide rail block 433. The second guide rail block 433 is fastened to the bearing bracket 400. Because opening and closing of the bearing bracket 400 correspond to the open state and the closed state of the hinge apparatus 10, an increase in the opening/closing angle of the second guide rail block 433 helps increase the opening/closing angle of the bearing bracket 400. In this way, the hinge apparatus 10 can be opened to a larger angle, to meet application requirements in different scenarios.

In an implementation, the second rotating member 520 of the base 500 is a second sliding groove 530 (as shown in FIG. 26) located on an inner side of the base 500, where the second sliding groove 530 is in an arc shape. Second slide protrusions 4322 (as shown in FIG. 26) are correspondingly provided at two ends of the first guide rail block 432 in the second direction B, and the second sliding groove 530 fits the second slide protrusion 4322, to implement a rotatable connection between the base 500 and the first guide rail block 432. In an implementation, there may be one or two second sliding grooves 530 and one or two second slide protrusions 4322.

In an implementation, third sliding grooves 4323 (as shown in FIG. 26) are provided on inner walls of two ends of the first accommodation groove 4321 in the second direction B, third slide protrusions 4331 (as shown in FIG. 26) are provided on an outer wall of the second guide rail block 433 in the second direction B, and the third sliding grooves 4323 fit the third slide protrusions 4331, to implement a rotatable connection between the first guide rail block 432 and the second guide rail block 433. In an implementation, a slide protrusion (not shown in the figure) is provided on an inner wall of the first accommodation groove 4321 in the second direction B, and a sliding groove (not shown in the figure) is provided on an outer wall of the second guide rail block 433 in the second direction B.

In an implementation, the base 500 is in interference fit with the first guide rail block 432. According to this solution, a friction force is increased, so that a torque is increased. In this implementation, the base 500 is in interference fit with the bearing bracket 400 through the interference fit between the base 500 and the first guide rail block 432.

In an implementation, the first guide rail block 432 is in interference fit with the second guide rail block 433. According to this solution, a friction force is increased, so that a torque is increased.

In an implementation, the base 500 is in interference fit with the first guide rail block 432, and the first guide rail block 432 is in interference fit with the second guide rail block 433. In this solution, a torque is increased through two-stage interference fit.

Still refer to FIG. 25 and FIG. 26. In an implementation, the second guide rail block 433 includes a second accommodation groove 4332 whose opening is away from the bottom of the base 500, and the first end 110 of the first shaft sleeve assembly 100 is located in the second accommodation groove 4332 and is fastened to the second guide rail block 433.

In an implementation, a first avoidance sub-groove 4333 (as shown in FIG. 26) is provided in the second accommodation groove 4332, a second avoidance sub-groove 4334 is provided at an end that is of the bearing bracket 400 and that is close to the second guide rail block 433, and the first avoidance sub-groove 4333 fits the second avoidance sub-groove 4334 to form an avoidance groove. The first shaft core 200 passes through the first end 110 of the first shaft sleeve assembly 100, and two ends of the first end 110 are located in the avoidance groove formed by the first avoidance sub-groove 4333 and the second avoidance sub-groove 4334, so that the end of the bearing bracket 400, the first end 110 of the first shaft sleeve assembly 100, and the first shaft core 200 are located in the second accommodation groove 4332 of the second guide rail block 433 (as shown in FIG. 26). According to this solution, the hinge apparatus 10 can be smaller in size.

The following describes an assembly method and total torque analysis according to the second embodiment of this application. Still refer to FIG. 24 to FIG. 26. In a process of assembling the hinge apparatus 10 shown in FIG. 24, the first end 110 of the first shaft sleeve assembly 100 is first sleeved on the first shaft core 200, then, the first end 110 of the first shaft sleeve assembly 100 is placed in the second accommodation groove 4332 of the second guide rail block 433, and the bearing bracket 400 is fastened to the second guide rail block 433 via a screw. In this way, the first avoidance sub-groove 4333 of the second accommodation groove 4332 fits the second avoidance sub-groove 4334 of the bearing bracket 400 to form the avoidance groove. The two ends of the first end 110 of the first shaft sleeve assembly 100 are located in the avoidance groove formed by the first avoidance sub-groove 4333 and the second avoidance sub-groove 4334, so that the end of the bearing bracket 400, the first end 110 of the first shaft sleeve assembly 100, and the first shaft core 200 are located in the second accommodation groove 4332 of the second guide rail block 433. Then, the second guide rail block 433 is placed in the first accommodation groove 4321 of the first guide rail block 432, and the third slide protrusions 4331 of the second guide rail block 433 slide into the third sliding grooves 4323 of the first guide rail block 432.

The second end 120 of the first shaft sleeve assembly 100 is sleeved on the second shaft core 300, and then two ends of the second shaft core 300 penetrate the fastening holes 810 of the shaft core fastener 800. Structures of the first shaft sleeve assembly 100, the first shaft core 200, the second shaft core 300, and the shaft core fastener 800 are shown in FIG. 28. The sliding plate 700 is mounted into the base 500 via the sliding plate assembly hole 513 and slides into the second groove 512 of the support plate 510, then, the sliding plate 700 is fastened to the shaft core fastener 800 via a screw, and the second slide protrusion 4322 of the first guide rail block 432 slides into the second sliding groove 530 from an end that is of the second sliding groove 530 and that is close to the second groove 512 in the first direction A. In this way, the hinge apparatus 10 finally presents the structure shown in FIG. 24. In the hinge apparatus 10 shown in FIG. 24, the base 500 is integrally formed, so that structural strength of the hinge apparatus 10 can be improved, and a welding process can be reduced. In addition, the hinge apparatus 10 has a disassembly and assembly manner of disassembling components from top to bottom, which helps reduce operation difficulty and costs of assembly and rework.

In this embodiment, when the user exerts an acting force to the bearing bracket 400 to open the bearing bracket 400 relative to the base 500, the bearing bracket 400 and the second guide rail block 433 rotate synchronously, to drive the first guide rail block 432 to rotate relative to the base 500, and further drive the first end 110 of the first shaft sleeve assembly 100 to rotate relative to the first shaft core 200, and the second end 120 of the first shaft sleeve assembly 100 to rotate relative to the second shaft core 300. In this way, the sliding plate 700 slides relative to the base 500. When the hinge apparatus 10 is in the open state, the sliding plate 700, the second shaft core 300, and the first shaft sleeve assembly 100 are located on a back side that is of the bearing bracket 400 and that is open relative to the base 500, so that the bearing bracket 400 can properly shield the first shaft sleeve assembly 100, the first shaft core 200, and the second shaft core 300 inside the hinge apparatus 10. Therefore, when the hinge apparatus 10 is used in the electronic device 1, an appearance of the electronic device 1 is more exquisite.

In the hinge apparatus 10 shown in FIG. 24, the first end 110 of the first shaft sleeve assembly 100 is in interference fit with the first shaft core 200, and interference fit exists at at least one of the following locations: between the second end 120 of the first shaft sleeve assembly 100 and the second shaft core 300, between the sliding plate 700 and the base 500, between the second guide rail block 433 and the first guide rail block 432, or between the first guide rail block 432 and the base 500.

In an implementation, Mₜₒₜₐₗ=k₁×M₁+k₂×M₂+k₅×M₅+k₆×M₆+k₇×M₇. Herein, Mₜₒₜₐₗ is a total torque in the embodiment shown in FIG. 24, M₁ is generated at a location at which the first shaft core 200 is in interference fit with the first end 110 of the first shaft sleeve assembly 100, M₂ is generated at a location at which the second shaft core 300 is in interference fit with the second end 120 of the first shaft sleeve assembly 100, M₅ is generated at a location at which the first guide rail block 432 is rotatably connected to the second guide rail block 433, M₆ is generated at a location at which the first guide rail block 432 is rotatably connected to the second sliding groove 530 of the base 500, a torque M7 is generated at a location at which the sliding plate 700 is slidably connected to the base 500, and k₁, k₂, k₅, k₆, and k₇ are contribution coefficients of the locations at which the torques are generated to the total torque. The total torque of the hinge apparatus 10 can be comprehensively increased through the foregoing five locations of interference fit.

In some implementations, interference fit may be set at some locations to generate torques. For example, Mₜₒₜₐₗ=k₁×M₁+k₂×M₂+k₅×M₅. For example, Mₜₒₜₐₗ=k₁×M₁+k₂×M₂+k₅×M₅+k₆×M₆.

The following describes a possible implementation of the hinge apparatus 10 according to a third embodiment of this application.

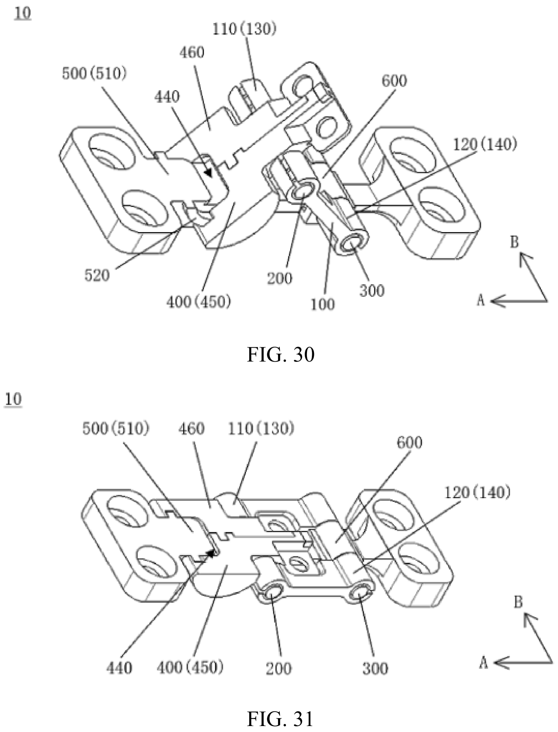

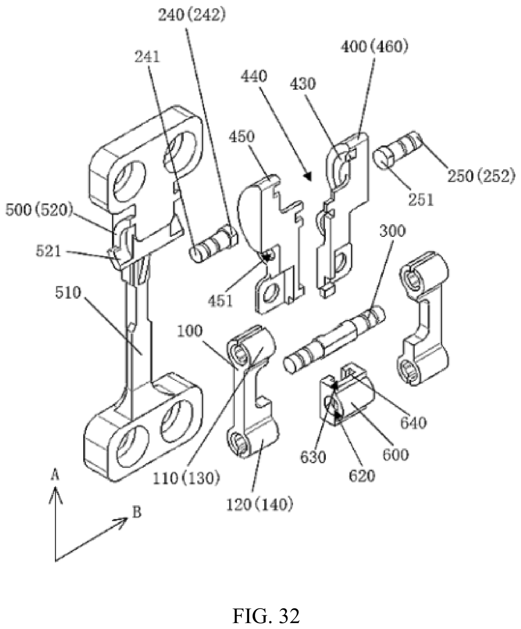

Refer to FIG. 30 to FIG. 32. FIG. 30 is a diagram of a structure of the hinge apparatus 10 in an open state according to the third embodiment of this application. FIG. 31 is a diagram of a structure of the hinge apparatus 10 shown in FIG. 30 in a closed state according to the third embodiment. FIG. 32 is an exploded view of the hinge apparatus 10 shown in FIG. 30 according to the third embodiment.

In an implementation, the hinge apparatus 10 has an open state and a closed state, and the hinge apparatus 10 includes a base 500, a bearing bracket 400, a first shaft core 200, a second shaft core 300, and a first shaft sleeve assembly 100 (as shown in FIG. 32). The bearing bracket 400 is rotatably connected to the base 500, for the bearing bracket 400 to be opened or closed relative to the base 500 (with reference to FIG. 30 and FIG. 31). The first shaft core 200 is fastened to the bearing bracket 400 (as shown in FIG. 30). The second shaft core 300 is slidably connected to the base 500 (with reference to FIG. 30 to FIG. 32). A first end 110 of the first shaft sleeve assembly 100 is sleeved on the first shaft core 200 and is capable of rotating relative to the first shaft core 200 (with reference to FIG. 30 to FIG. 32), a second end 120 of the first shaft sleeve assembly 100 is sleeved on the second shaft core 300 and is capable of rotating relative to the second shaft core 300 (with reference to FIG. 30 to FIG. 32), and the two ends of the first shaft sleeve assembly 100 are respectively in interference fit with the first shaft core 200 and the second shaft core 300, to enable the first shaft sleeve assembly 100 and each of the first shaft core 200 and the second shaft core 300 to be configured to provide a torque for the hinge apparatus 10 in a process in which the hinge apparatus 10 switches between the open state and the closed state.

In an implementation, Mₜₒₜₐₗ=k₁×M₁+k₂×M₂. Herein, Mₜₒₜₐₗ is a total torque in the embodiment shown in FIG. 30, M₁ is generated at a location at which the first shaft core 200 is in interference fit with the first end 110 of the first shaft sleeve assembly 100, and M₂ is generated at a location at which the second shaft core 300 is in interference fit with the second end 120 of the first shaft sleeve assembly 100. The torques are generated at the foregoing two locations, so that the overall torque Mₜₒₜₐₗ of the hinge apparatus 10 can be increased. In this way, the hinge apparatus 10 can support a larger electronic device or support the electronic device at a large angle. Alternatively, when the supported electronic device is determined, a volume of the hinge apparatus 10 may be reduced, which helps implement a light and thin design of the entire electronic device. For specific analysis of beneficial effect brought by interference fit between the two ends of the first shaft sleeve assembly 100, and the first shaft core 200 and the second shaft core 300, refer to the first embodiment. Details are not described herein again.

It should be noted that Example 1, Example 2, and Example 3 of the first shaft sleeve 130 and the second shaft sleeve 140 in the first embodiment are also applicable to the possible implementation of the first shaft sleeve 130 and the second shaft sleeve 140 in the second embodiment.

The following describes a possible implementation of the second shaft core 300 and the base 500 according to the third embodiment of this application. Still refer to FIG. 30 to FIG. 32. Different from that in the first embodiment, in the third embodiment, the hinge apparatus 10 includes one sliding block 600 (as shown in FIG. 30 to FIG. 32). The sliding block 600 is provided with a through hole 620 (as shown in FIG. 32) that penetrates the sliding block 600 in a second direction B, the second shaft core 300 penetrates the through hole 620 and is fastened to the sliding block 600 (with reference to FIG. 30 and FIG. 32), two ends of the second shaft core 300 penetrate the through hole 620, and the second end 120 of the first shaft sleeve assembly 100 is sleeved on at least one end of the second shaft core 300 and can rotate relative to the second shaft core 300 (with reference to FIG. 30 and FIG. 32). The base 500 includes a support plate 510 (as shown in FIG. 30 to FIG. 32) that extends in a first direction A, the sliding block 600 has a slide groove 630 (as shown in FIG. 32) whose opening faces the support plate 510, the support plate 510 penetrates the slide groove 630 in the first direction A, and the sliding block 600 can slide relative to the support plate 510 (with reference to FIG. 30 to FIG. 32). The first direction A intersects the second direction B, and the second direction B is parallel to an axis of the second shaft core 300.

In this implementation, the through hole 620 penetrates two end faces of the sliding block 600 in the second direction B, a part between two ends of the second shaft core 300 is fastened to the sliding block 600 via the through hole 620, and the second end 120 of the first shaft sleeve assembly 100 is sleeved on at least one end of the second shaft core 300, to implement a rotatable connection between the second end 120 of the first shaft sleeve assembly 100 and the second shaft core 300.

In this implementation, the base 500 has only one support plate 510, and is presented as a stiffener structure as a whole. A hook portion 640 (as shown in FIG. 32) is provided at an end that is of the sliding block 600 and that faces the support plate 510, and the hook portion 640 is clamped on the support plate 510. In this way, the support plate 510 penetrates the slide groove 630 and is not detached from the slide groove 630, so that the sliding block 600 is slidably connected to the support plate 510 in the first direction A. The slide groove 630 communicates with the through hole 620, the slide groove 630 slides in an extension direction of the support plate 510, a part of the second shaft core 300 located in the through hole 620 is fastened to the sliding block 600, and the two ends of the second shaft core 300 are rotatably connected to the second end 120 of the first shaft sleeve assembly 100, so that the second end 120 of the first shaft sleeve assembly 100 slides relative to the support plate 510.

In an implementation, interference fit exists at at least one of the following locations: between the second shaft core 300 and an inner wall of the through hole 620, between the support plate 510 and an inner wall of the slide groove 630 of the sliding block 600, or between the second end 120 of the first shaft sleeve assembly 100 and the second shaft core 300. According to this solution, a torque of the hinge apparatus 10 can be increased, and further support stability of the hinge apparatus 10 can be improved.

In this implementation, the second shaft core 300 and the base 500 are in indirect contact and in interference fit with each other through the interference fit between the support plate 510 and the inner wall of the slide groove 630 of the sliding block 600.

In an implementation, an arc-shaped sliding groove (not shown in the figure) is provided at an end that is of the hook portion 640 of the sliding block 600 and that faces the slide groove 630, arc-shaped slide protrusions are provided at two ends of the support plate 510 in the second direction B, and the sliding groove fits the slide protrusions, to implement a sliding connection between the sliding block 600 and the base 500. An extension direction of the arc shape has a component in the first direction A.

The following describes a possible implementation of the bearing bracket 400 and the base 500 according to the third embodiment of this application. Still refer to FIG. 32. In an implementation, a rotating groove 440 is provided at an end of the bearing bracket 400, the support plate 510 is located between groove walls at two ends of the rotating groove 440 in the second direction B, and two sides of the support plate 510 in the second direction B are rotatably connected to the groove walls of the rotating groove 440. The second direction B intersects the first direction A and is parallel to the first shaft core 200. In this implementation, the base 500 has only one support plate 510, and is presented as a stiffener structure as a whole. The support plate 510 fits the rotating groove 440, to implement a rotation connection between the base 500 and the bearing bracket 400.

In an implementation, a first rotating member 430 is provided on an inner wall of the rotating groove 440, and second rotating members 520 (as shown in FIG. 32) are provided on two sides of the support plate 510 in the second direction B. The second rotating members 520 may be slide protrusions, and the first rotating member 430 may be a sliding groove. The slide protrusion fits the sliding groove, so that the support plate 510 is rotatably connected to the bearing bracket 400.

In an implementation, the first rotating member 430 is in interference fit with the second rotating member 520. According to this solution, a friction force generated when the second rotating member 520 rotates relative to the first rotating member 430 can be used to increase the total torque provided by the hinge apparatus 10.

In an implementation, the bearing bracket 400 includes a first sub-bearing bracket 450 and a second sub-bearing bracket 460 (as shown in FIG. 32) that are arranged in the second direction B and are spaced apart. The first sub-bearing bracket 450 is fastened to the second sub-bearing bracket 460 through welding, via a screw, or the like. There are notches facing each other at an end of the first sub-bearing bracket 450 and an end of the second sub-bearing bracket 460. The two notches are combined to form the rotating groove 440. The first rotating member 430 is provided on the inner wall of the rotating groove 440, and the second rotating member 520 is provided on the support plate 510. The first rotating member 430 fits the second rotating member 520 to implement a rotating connection.

In an implementation, the second rotating member 520 further includes a stop portion 521 (as shown in FIG. 32) protruding toward the first rotating member 430, and the stop portion 521 is located at an end of the second rotating member 520 in the first direction A. When the first rotating member 430 rotates relative to the second rotating member 520 to the stop portion 521, the first rotating member 430 stops rotating.

In an implementation, the first rotating member 430 on the rotating groove 440 is a slide protrusion, and the second rotating member 520 on the support plate 510 is a sliding groove.

Still refer to FIG. 30 to FIG. 32. In an implementation, the first sub-bearing bracket 450 and the second sub-bearing bracket 460 are provided with shaft core fastening holes 451 (as shown in FIG. 32), the first shaft core 200 includes a first sub-shaft core 240 and a second sub-shaft core 250 that are disposed opposite to each other, the first sub-shaft core 240 includes a first end 241 and a second end 242, and the second sub-shaft core 250 includes a first end 251 and a second end 252. The second end 242 of the first sub-shaft core 240 and the first end 251 of the second sub-shaft core 250 are respectively located in the shaft core fastening holes 451 of the first sub-bearing bracket 450 and the second sub-bearing bracket 460, so that the first sub-shaft core 240 is fastened to the first sub-bearing bracket 450, and the second sub-shaft core 250 is fastened to the second sub-bearing bracket 460. The second end 120 of the first shaft sleeve assembly 100 is separately sleeved on the first end 241 of the first sub-shaft core 240 and the second end 252 of the second sub-shaft core 250, so that the second end 120 of the first shaft sleeve assembly 100 is rotatably connected to the first sub-shaft core 240 and the second sub-shaft core 250.

In this implementation, the first shaft sleeve assembly 100 includes two first shaft sleeve sub-assemblies (not shown in the figure), and a first end 110 of one of the first shaft sleeve sub-assemblies is sleeved on the first sub-shaft core 240, a first end of the other first shaft sleeve sub-assembly is sleeved on the second sub-shaft core 250.

In the hinge apparatus 10 shown in FIG. 30, the first end 110 of the first shaft sleeve assembly 100 is in interference fit with the first sub-shaft core 240 and the second sub-shaft core 250. Interference fit exists at at least one of the following locations: between the second end 120 of the first shaft sleeve assembly 100 and the second shaft core 300, between the sliding block 600 and the support plate 510, and between the bearing bracket 400 and the support plate 510.

The following describes an assembly method and total torque analysis according to the third embodiment of this application. Still refer to FIG. 30 to FIG. 32. In a process of assembling the hinge apparatus 10 shown in FIG. 30, the second end 242 of the first sub-shaft core 240 and the first end 251 of the second sub-shaft core 250 first respectively pass through the shaft core fastening hole 451 of the first sub-bearing bracket 450 and the shaft core fastening hole 451 of the second sub-bearing bracket 460, and the second shaft core 300 passes through the through hole 620 of the sliding block 600. Then, the first end of the first shaft sleeve assembly 100 is separately sleeved on the first end 241 of the first sub-shaft core 240 and the second end 252 of the second sub-shaft core 250, and the second end 120 of the first shaft sleeve assembly 100 is sleeved at two ends of the second shaft core 300. Finally, the slide groove 630 of the sliding block 600 is clamped to the support plate 510, and the first rotating member 430 of the bearing bracket 400 slides into the second rotating member 520 of the base 500. In this way, the hinge apparatus 10 finally presents the structure shown in FIG. 30.

In an implementation, Mₜₒₜₐₗ=k₁×M₁+k₂×M₂+k₃×M₃+k₄×M₄. Herein, Mₜₒₜₐₗ is a total torque in the embodiment shown in FIG. 30, M₁ is generated at a location at which the first shaft core 200 is in interference fit with the first end 110 of the first shaft sleeve assembly 100, M₂ is generated at a location at which the second shaft core 300 is in interference fit with the second end 120 of the first shaft sleeve assembly 100, M₃ is generated at a location at which the bearing bracket 400 is rotatably connected to the base 500, a torque M₄ is generated at a location at which the sliding block 600 is slidably connected to the base 500, and k₁ to k₄ are contribution coefficients of the locations at which the torques are generated to the total torque. The contribution coefficients are related to a structure layout and a size of the hinge apparatus. For details, refer to related descriptions in FIG. 8. The torques are generated at the foregoing four locations, so that the overall torque Mₜₒₜₐₗ of the hinge apparatus 10 can be increased. In this way, the hinge apparatus 10 can support a larger electronic device or support the electronic device at a large angle. Alternatively, when the supported electronic device is determined, a volume of the hinge apparatus 10 may be reduced, which helps implement a light and thin design of the entire electronic device.

In some implementations, interference fit may be set at some locations to generate torques. For example, Mₜₒₜₐₗ=k₁×M₁+k₂×M₂+k₃×M₃. For example, Mₜₒₜₐₗ=k₁×M₁+k₂×M₂+k₄×M₄.

The following describes a possible implementation of the hinge apparatus 10 according to a fourth embodiment of this application.

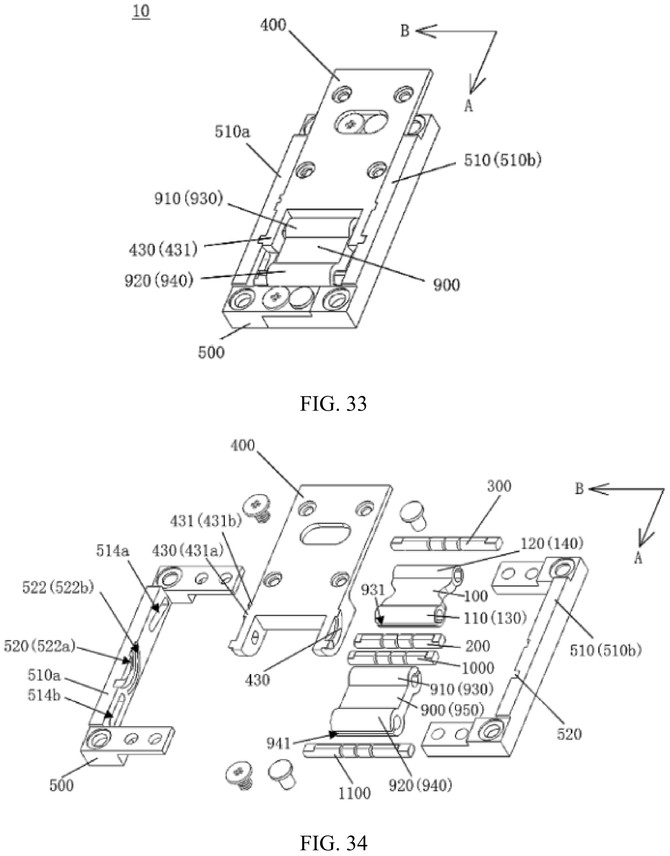

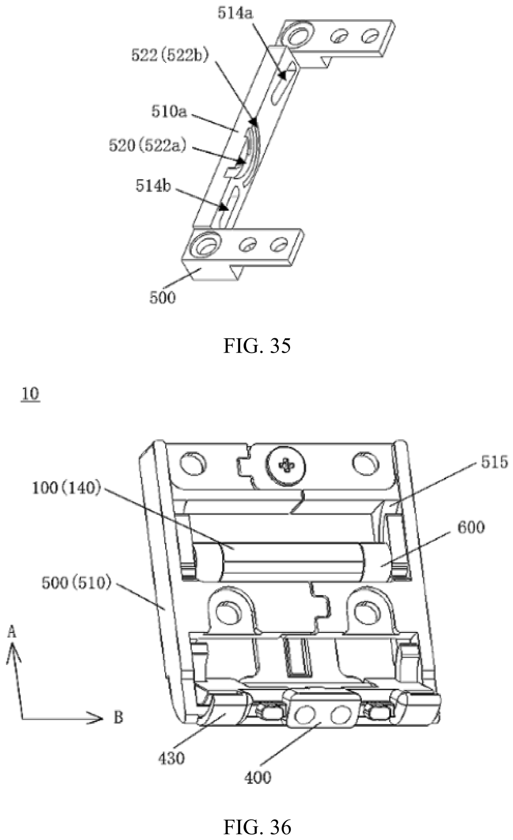

Refer to FIG. 33 to FIG. 35. FIG. 33 is a diagram of a structure of the hinge apparatus 10 in a closed state according to the fourth embodiment of this application. FIG. 34 is an exploded view of the hinge apparatus 10 shown in FIG. 33 according to the fourth embodiment. FIG. 35 is a diagram of a partial structure of the hinge apparatus 10 shown in FIG. 33 according to the fourth embodiment.

In an implementation, the hinge apparatus 10 has an open state and a closed state, and the hinge apparatus 10 includes a base 500, a bearing bracket 400, a first shaft core 200, a second shaft core 300, and a first shaft sleeve assembly 100 (as shown in FIG. 34). The bearing bracket 400 is rotatably connected to the base 500, for the bearing bracket 400 to be opened or closed relative to the base 500 (with reference to FIG. 33 and FIG. 34). The first shaft core 200 is fastened to the bearing bracket 400 (as shown in FIG. 34). The second shaft core 300 is slidably connected to the base 500 (with reference to FIG. 33 and FIG. 34). A first end 110 of the first shaft sleeve assembly 100 is sleeved on the first shaft core 200 and is capable of rotating relative to the first shaft core 200 (with reference to FIG. 33 and FIG. 34), a second end 120 of the first shaft sleeve assembly 100 is sleeved on the second shaft core 300 and is capable of rotating relative to the second shaft core 300 (with reference to FIG. 33 and FIG. 34), and the two ends of the first shaft sleeve assembly 100 are respectively in interference fit with the first shaft core 200 and the second shaft core 300, to enable the first shaft sleeve assembly 100 and each of the first shaft core 200 and the second shaft core 300 to be configured to provide a torque for the hinge apparatus 10 in a process in which the hinge apparatus 10 switches between the open state and the closed state.

In an implementation, Mₜₒₜₐₗ=k₁×M₁+k₂×M₂. Herein, Mₜₒₜₐₗ is a total torque in the embodiment shown in FIG. 33, M₁ is generated at a location at which the first shaft core 200 is in interference fit with the first end 110 of the first shaft sleeve assembly 100, and M₂ is generated at a location at which the second shaft core 300 is in interference fit with the second end 120 of the first shaft sleeve assembly 100. The torques are generated at the foregoing two locations, so that the overall torque Mₜₒₜₐₗ of the hinge apparatus 10 can be increased. In this way, the hinge apparatus 10 can support a larger electronic device or support the electronic device at a large angle. Alternatively, when the supported electronic device is determined, a volume of the hinge apparatus 10 may be reduced, which helps implement a light and thin design of the entire electronic device. For specific analysis of beneficial effect brought by interference fit between the two ends of the first shaft sleeve assembly 100, and the first shaft core 200 and the second shaft core 300, refer to the first embodiment. Details are not described herein again.

The following describes a possible implementation of a second shaft sleeve assembly 900, a third shaft core 1000, and a fourth shaft core 1100 according to the fourth embodiment of this application. Refer to FIG. 34. Different from that in the first embodiment, in the fourth embodiment, the hinge apparatus 10 further includes the second shaft sleeve assembly 900, the third shaft core 1000, and the fourth shaft core 1100. The first shaft sleeve assembly 100 and the second shaft sleeve assembly 900 are located on two sides of a rotation center at which the bearing bracket 400 rotates around the base 500. The third shaft core 1000 is fastened to the bearing bracket 400, and the fourth shaft core 1100 is slidably connected to the base 500. A first end 910 of the second shaft sleeve assembly 900 is sleeved on the third shaft core 1000 and is capable of rotating relative to the third shaft core 1000, and a second end 920 of the second shaft sleeve assembly 900 is sleeved on the fourth shaft core 1100 and is capable of rotating relative to the fourth shaft core 1100, and the two ends of the second shaft sleeve assembly 900 are respectively in interference fit with the third shaft core 1000 and the fourth shaft core 1100, to enable the second shaft sleeve assembly 900 and each of the third shaft core 1000 and the fourth shaft core 1100 to be configured to provide a torque for the hinge apparatus 10 in a process in which the hinge apparatus 10 switches between the open state and the closed state.

In this implementation, two ends of the first shaft core 200 and two ends of the third shaft core 1000 are fastened to the bearing bracket 400, and the second shaft core 300 and the fourth shaft core 1100 are slidably connected to the base 500. The second shaft sleeve assembly 900 includes a third shaft sleeve 930, a fourth shaft sleeve 940, and a second connecting rod 950. The second connecting rod 950 is connected between the third shaft sleeve 930 and the fourth shaft sleeve 940. The third shaft sleeve 930 is located at the first end 910 of the second shaft sleeve assembly 900, and the third shaft sleeve 930 is sleeved on the third shaft core 1000, is capable of rotating relative to the third shaft core 1000, and is in interference fit with the third shaft core 1000. The fourth shaft sleeve 940 is located at the second end 920 of the second shaft sleeve assembly 900, and the fourth shaft sleeve 940 is sleeved on the fourth shaft core 1100, is capable of rotating relative to the fourth shaft core 1100, and is in interference fit with the fourth shaft core 1100. The second connecting rod 950 is configured to transmit power from the third shaft sleeve 930 to the fourth shaft sleeve 940, so that the second shaft sleeve assembly 900 rotates as a whole. The third shaft sleeve 930 is in interference fit with the third shaft core 1000, and the fourth shaft sleeve 940 is in interference fit with the fourth shaft core 1100, so that friction forces generated when the third shaft core 1000 rotates relative to the third shaft sleeve 930 and generated when the fourth shaft core 1100 rotates relative to the fourth shaft sleeve 940 can be used to increase a torque provided by the hinge apparatus 10. This improves stability of the hinge apparatus 10 when the hinge apparatus 10 supports the electronic device.

In an implementation, the third shaft sleeve 930, the second connecting rod 950, and the fourth shaft sleeve 940 are integrally formed. According to this solution, stability of an overall structure of the second shaft sleeve assembly 900 can be improved.

In an implementation, the third shaft sleeve 930 is provided with a third opening 931 that penetrates an inner surface and an outer surface of the third shaft sleeve 930, and the third opening 931 extends in an axial direction of the third shaft sleeve 930. In this solution, the third opening 931 is disposed in the third shaft sleeve 930, so that a rotation amplitude of the third shaft sleeve 930 relative to the third shaft core 1000 can be increased. In addition, the third opening 931 can be further used to increase elasticity of the third shaft sleeve 930, and reduce a contact area between the third shaft core 1000 and the third shaft sleeve 930. This helps reduce an amount of wear between the third shaft core 1000 and the third shaft sleeve 930, and further prolong a service life of the third shaft sleeve 930 assembly.

In an implementation, the fourth shaft sleeve 940 is provided with a fourth opening 941 that penetrates an inner surface and an outer surface of the fourth shaft sleeve 940, and the fourth opening 941 extends in an axial direction of the fourth shaft sleeve 940. In this solution, the fourth opening 941 is disposed in the fourth shaft sleeve 940, so that a rotation amplitude of the fourth shaft sleeve 940 relative to the fourth shaft core 1100 can be increased. In addition, the fourth opening 941 can be further used to increase elasticity of the fourth shaft sleeve 940, and reduce a contact area between the fourth shaft core 1100 and the fourth shaft sleeve 940. This helps reduce an amount of wear between the fourth shaft core 1100 and the fourth shaft sleeve 940, and further prolong a service life of the fourth shaft sleeve 940 assembly.

In an implementation, a third shaft sleeve plane part (not shown in the figure) is provided on the inner surface of the third shaft sleeve 930, and a third shaft core plane part (not shown in the figure) parallel to the third shaft sleeve plane part is provided on an outer surface of the third shaft core 1000. In the closed state, the third shaft sleeve plane part and the third shaft core plane part are disposed opposite to each other. In another implementation, in the closed state, there is a third included angle between the third shaft sleeve plane part and the third shaft core plane part (not shown in the figure). For specific descriptions of locking the hinge apparatus by the third shaft sleeve plane part and the third shaft core plane part at different angles, refer to related content of the first shaft sleeve plane part and the first shaft core plane part. Details are not described herein again.

In an implementation, a fourth shaft sleeve plane part (not shown in the figure) is provided on the inner surface of the fourth shaft sleeve 940, and a fourth shaft core plane part (not shown in the figure) parallel to the fourth shaft sleeve plane part is provided on an outer surface of the fourth shaft core 1100. In the closed state, the fourth shaft sleeve plane part and the fourth shaft core plane part are disposed opposite to each other. In another implementation, in the closed state, there is a third included angle between the fourth shaft sleeve plane part and the fourth shaft core plane part (not shown in the figure). For specific descriptions of locking the hinge apparatus by the fourth shaft sleeve plane part and the fourth shaft core plane part at different angles, refer to related content of the first shaft sleeve plane part and the first shaft core plane part. Details are not described herein again.

In an implementation, in the closed state, the third shaft sleeve plane part and the third shaft core plane part are disposed opposite to each other or there is the third included angle between the third shaft sleeve plane part and the third shaft core plane part, or the fourth shaft sleeve plane part and the fourth shaft core plane part are disposed opposite to each other or there is the third included angle between the fourth shaft sleeve plane part and the fourth shaft core plane part.

In an implementation, the third shaft sleeve 930, the second connecting rod 950, and the fourth shaft sleeve 940 are sheet metal parts or metal injection molded parts. In this implementation, a sheet metal machining technique enables machining procedures of the third shaft sleeve 930, the second connecting rod 950, and the fourth shaft sleeve 940 to be simple, and facilitates large-scale production. An MIM technology has advantages such as high efficiency, low costs, and high precision. The third shaft sleeve 930, the second connecting rod 950, and the fourth shaft sleeve 940 can be quickly and accurately manufactured by using the MIM technology.

Still refer to FIG. 33 to FIG. 35. In the hinge apparatus 10 shown in FIG. 33, the base 500 includes a first support plate 510a and a second support plate 510b that are arranged in a second direction B and are spaced apart, and the first support plate 510a and the second support plate 510b each are provided with a first base sliding groove 514a and a second base sliding groove 514b. The second rotating member 520 is located between the first base sliding groove 514a and the second base sliding groove 514b in the first direction A, the second shaft core 300 is located in the first base sliding groove 514a and is in interference fit with the first base sliding groove 514a (not shown in the figure), and the fourth shaft core 1100 is located in the second base sliding groove 514b and is in interference fit with the second base sliding groove 514b (not shown in the figure).

In an implementation, the first base sliding groove 514a and the second base sliding groove 514b extend in the first direction A, so that the third shaft core 1000 and the fourth shaft core 1100 can slide relative to the base 500 in the first direction A.

In an implementation, the first base sliding groove 514a and the second base sliding groove 514b extend in a fourth direction, where the fourth direction has a component in the first direction A. The fourth direction and the first direction A are provided at an included angle and are both parallel to the first support plate 510a.

In an implementation, the first base sliding groove 514a and the second base sliding groove 514b extend in an arc direction, where the arc direction has a component in the first direction A.

It should be noted that, in this application, a plurality of implementations of location relationships between the first shaft core 200 and a virtual central axis and between the second shaft core 300 and a virtual central axis, a plurality of implementations of the first shaft sleeve assembly 100, a plurality of implementations of the second shaft core 300 and the base 500, a plurality of implementations of the bearing bracket 400 and the base 500, and the implementation of the second shaft sleeve assembly 900, the third shaft core 1000, and the fourth shaft core 1100 may be used in combination, and are not limited to the embodiments shown in the accompanying drawings of this application.

The following describes a possible implementation of the bearing bracket 400 and the base 500 according to the fourth embodiment of this application. Still refer to FIG. 33 to FIG. 35. In an implementation, the second rotating member 520 includes two arc-shaped first sliding grooves 522 (as shown in FIG. 34). Curvature centers of the two first sliding grooves 522 are disposed on a same side and are away from the bottom of the base 500 (as shown in FIG. 34 and FIG. 35). The first rotating member 430 includes two arc-shaped first slide protrusions 431 (as shown in FIG. 33 and FIG. 34). The two first slide protrusions 431 are respectively located in the two first sliding grooves 522 and can slide relative to the first sliding grooves 522 (as shown in FIG. 33 and FIG. 34).

In this implementation, the two first sliding grooves 522 are respectively denoted as a first sliding groove 522a and a first sliding groove 522b (as shown in FIG. 34), and the two first slide protrusions 431 are respectively denoted as a first slide protrusion 431a and a first slide protrusion 431b (as shown in FIG. 34). The first slide protrusion 431a rotates in the first sliding groove 522a, the first slide protrusion 431a rotates in the first sliding groove 522a. If the second rotating member 520 includes only the first sliding groove 522a, and the first rotating member 430 includes only the first slide protrusion 431a, because an extension path of the first sliding groove 522a matches a movement path of the first slide protrusion 431a, a friction force generated when the first slide protrusion 431a rotates in the first sliding groove 522a is small, and consequently, a torque that can be provided is limited. In this solution, another first sliding groove 522b and another first slide protrusion 431b are added in addition to the first sliding groove 522a and the first slide protrusion 431a. During actual machining, curvature of the first sliding groove 522a and curvature of the first sliding groove 522b are adjusted through mutual matching between design tolerances, so that interference fit can be easily implemented between the first rotating member 430 and the second rotating member 520. That is, when the first rotating member 430 rotates in the second rotating member 520, a large friction force is generated, and therefore a torque can be provided. This helps more precisely control a movement gap.

In an implementation, second rotating members 520 are respectively provided on two sides of the base 500 in the second direction B. Quantities of sliding grooves in the second rotating members 520 on the two sides may be different, to be specific, the second rotating member 520 on one side includes an arc-shaped sliding groove, and the second rotating member 520 on the other side includes two arc-shaped sliding grooves. A quantity of slide protrusions in the first rotating member 430 of the bearing bracket 400 is set corresponding to a quantity of sliding grooves in the second rotating member 520.

In an implementation, the first rotating member 430 includes two arc-shaped sliding grooves (not shown in the figure), and the second rotating member 520 includes two arc-shaped slide protrusions (not shown in the figure). The two slide protrusions are respectively located in the two sliding grooves and can slide relative to the sliding grooves.

The following describes an assembly method and total torque analysis according to the fourth embodiment of this application. Still refer to FIG. 33 and FIG. 34. In a process of assembling the hinge apparatus 10 shown in FIG. 33, an assembly method for the first shaft sleeve assembly 100, the first shaft core 200, the second shaft core 300, and the bearing bracket 400 is the same as the assembly method in the hinge apparatus shown in FIG. 5. Details are not described herein again. After the first shaft sleeve assembly 100, the first shaft core 200, the second shaft core 300, and the bearing bracket 400 are assembled, the third shaft core 1000 penetrates the first end 910 of the second shaft sleeve assembly 900 and a through hole of the bearing bracket 400, the third shaft core 1000 and the first end 910 of the second shaft sleeve assembly 900 can rotate relative to each other, the third shaft core 1000 is fastened relative to the through hole of the bearing bracket 400, the fourth shaft core 1100 penetrates the second end 920 of the second shaft sleeve assembly 900, and the fourth shaft core 1100 and the second end 920 of the second shaft sleeve assembly 900 can rotate relative to each other. The two ends of the second shaft core 300 penetrate the first base sliding groove 514a of the base 500, and the two ends of the fourth shaft core 1100 penetrate the second base sliding groove 514b of the base 500. Then, the first slide protrusion 431a of the bearing bracket 400 slides into the first sliding groove 522a of the base 500, and the first slide protrusion 431b of the bearing bracket 400 slides into the first sliding groove 522b of the base 500. Finally, the first support plate 510a and the second support plate 510b are fastened in the second direction B via a screw. In this way, the hinge apparatus 10 finally presents the structure shown in FIG. 33.

Still refer to FIG. 33 and FIG. 34. In an implementation, Mₜₒₜₐₗ=k₁×M₁+k₂×M₂+k₈×M₈+k₉×M₉. Herein, Mₜₒₜₐₗ is a total torque in the embodiment shown in FIG. 33, M₁ is generated at a location at which the first shaft core 200 is in interference fit with the first end 110 of the first shaft sleeve assembly 100, M₂ is generated at a location at which the second shaft core 300 is in interference fit with the second end 120 of the first shaft sleeve assembly 100, M₈ is generated at a location at which the third shaft core 1000 is in interference fit with the first end 910 of the second shaft sleeve assembly 900, and M₉ is generated at a location at which the fourth shaft core 1100 is in interference fit with the second end 920 of the second shaft sleeve assembly 900. The torques are generated at the foregoing four locations, so that the overall torque Mₜₒₜₐₗ of the hinge apparatus 10 can be increased. In this way, the hinge apparatus 10 can support a larger electronic device or support the electronic device at a large angle. Alternatively, when the supported electronic device is determined, a volume of the hinge apparatus 10 may be reduced, which helps implement a light and thin design of the entire electronic device.

In some implementations, Mₜₒₜₐₗ=k₁×M₁+k₂×M₂+k₈×M₈+k₉×M₉+k₁₀×M₁₀+k₁₁×M₁₁+k₁₂×M₁₂+k₁₃×M₁₃. Herein, M₁₀ is generated at a location at which the second shaft core 300 is slidably connected to the base 500, M₁₁ is generated at a location at which the fourth shaft core 1100 is slidably connected to the base 500, a torque M₁₂ is generated at a location at which the first slide protrusion 431a is connected to the first sliding groove 522a, a torque M₁₃ is generated at a location at which the first slide protrusion 431b is connected to the first sliding groove 522b, and k₁, k₂, k₈, k₉, k₁₀, k₁₁, k₁₂, and k₁₃ are contribution coefficients of the locations at which the torques are generated to the total torque.

In some implementations, interference fit may be set at some locations to generate torques.

For example, Mₜₒₜₐₗ=k₁×M₁+k₂×M₂+k₈×M₈+k₉×M₉+k₁₀×M₁₀+k₁₁×M₁₁.

For example, Mₜₒₜₐₗ=k₁×M₁+k₂×M₂+k₈×M₈+k₉×M₉+k₁₂×M₁₂+k₁₃×M₁₃.

The following describes a possible implementation of the hinge apparatus 10 according to a fifth embodiment of this application.

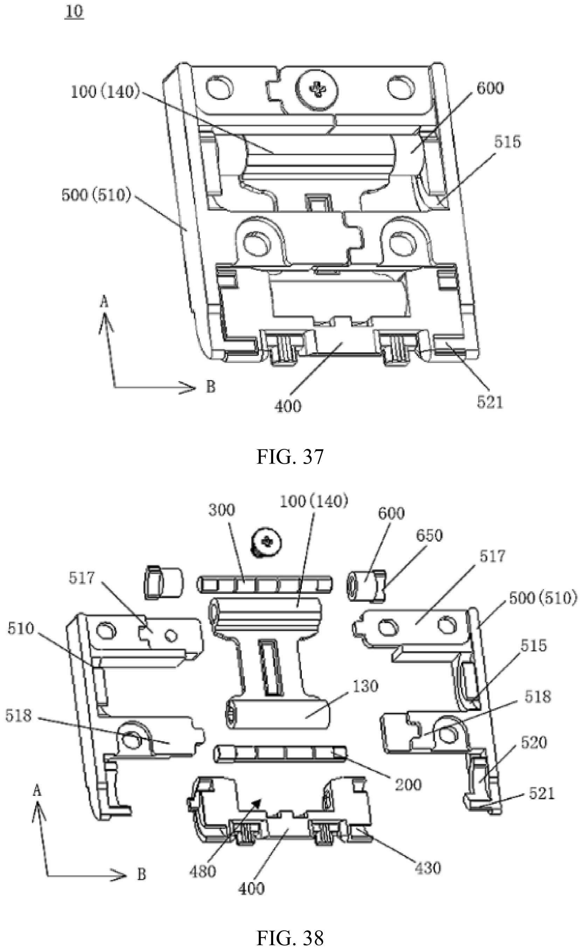

Refer to FIG. 36 to FIG. 38. FIG. 36 is a diagram of a structure of the hinge apparatus 10 in an open state according to the fifth embodiment of this application. FIG. 37 is a diagram of a structure of the hinge apparatus 10 shown in FIG. 36 in a closed state according to the fifth embodiment. FIG. 38 is an exploded view of the hinge apparatus 10 shown in FIG. 36 according to the fifth embodiment.

In an implementation, the hinge apparatus 10 has an open state and a closed state, and the hinge apparatus 10 includes a base 500, a bearing bracket 400, a first shaft core 200, a second shaft core 300, and a first shaft sleeve assembly 100 (as shown in FIG. 38). The bearing bracket 400 is rotatably connected to the base 500, for the bearing bracket 400 to be opened or closed relative to the base 500 (with reference to FIG. 36 and FIG. 37). The first shaft core 200 is fastened to the bearing bracket 400 (as shown in FIG. 38). The second shaft core 300 is slidably connected to the base 500 (with reference to FIG. 36 to FIG. 38). A first end 110 of the first shaft sleeve assembly 100 is sleeved on the first shaft core 200 and is capable of rotating relative to the first shaft core 200 (with reference to FIG. 36 to FIG. 38), a second end 120 of the first shaft sleeve assembly 100 is sleeved on the second shaft core 300 and is capable of rotating relative to the second shaft core 300 (with reference to FIG. 36 to FIG. 38), and the two ends of the first shaft sleeve assembly 100 are respectively in interference fit with the first shaft core 200 and the second shaft core 300, to enable the first shaft sleeve assembly 100 and each of the first shaft core 200 and the second shaft core 300 to be configured to provide a torque for the hinge apparatus 10 in a process in which the hinge apparatus 10 switches between the open state and the closed state.

In an implementation, Mₜₒₜₐₗ=k₁×M₁+k₂×M₂. Herein, Mₜₒₜₐₗ is a total torque in the embodiment shown in FIG. 38, M₁ is generated at a location at which the first shaft core 200 is in interference fit with a first shaft sleeve 130, and M₂ is generated at a location at which the second shaft core 300 is in interference fit with a second shaft sleeve 140. The torques are generated at the foregoing two locations, so that the overall torque Mₜₒₜₐₗ of the hinge apparatus 10 can be increased. In this way, the hinge apparatus 10 can support a larger electronic device or support the electronic device at a large angle. Alternatively, when the supported electronic device is determined, a volume of the hinge apparatus 10 may be reduced, which helps implement a light and thin design of the entire electronic device. For specific analysis of beneficial effect brought by interference fit between the two ends of the first shaft sleeve assembly 100, and the first shaft core 200 and the second shaft core 300, refer to the first embodiment. Details are not described herein again.

The following describes a possible implementation of the second shaft core 300 and the base 500 according to the fifth embodiment of this application. Still refer to FIG. 36 to FIG. 38. Different from that in the first embodiment, in the fifth embodiment, the hinge apparatus 10 includes two sliding blocks 600 (as shown in FIG. 36 to FIG. 38). Third rotating members 650 (as shown in FIG. 38) are provided at two ends of the two sliding blocks 600 that are back to each other in a second direction B, and two ends of the two sliding blocks 600 that face each other in the second direction B are respectively fastened to two ends of the second shaft core 300. The base 500 includes two fourth rotating members 515 (as shown in FIG. 38) disposed opposite to each other in the second direction B. The third rotating members 650 fit the fourth rotating members 515, so that the second shaft core 300 can slide relative to the base 500.

In an implementation, both the third rotating member 650 and the fourth rotating member 515 are disposed in an arc shape, so that the second shaft core 300 can slide relative to the base 500 in an arc direction. The arc direction has a component in the first direction A.

In this implementation, the third rotating member 650 may be a protrusion, and the fourth rotating member 515 may be a groove. The protrusion rotates in the groove, so that the sliding block 600 is rotatably connected to the base 500. A movement path of the sliding block 600 relative to the base 500 is a curve. Because the sliding block 600 is fastened to the second shaft core 300, the second shaft core 300 can also rotate relative to the base 500 in the arc direction. The arc direction has the component in the first direction A. In this way, in a process in which the second shaft core 300 rotates relative to the base 500, the second shaft core 300 is displaced in the first direction A.

The following describes a possible implementation of the bearing bracket 400 and the base 500 according to the fifth embodiment of this application. Still refer to FIG. 38. In an implementation, the base 500 includes two support plates 510 that are spaced apart in the second direction B, the bearing bracket 400 is located between the two support plates 510, first rotating members 430 are provided at two ends of the bearing bracket 400 in the second direction B, and second rotating members 520 are provided on two opposite end faces of the support plates 510 in the second direction B. The first rotating member 430 fits the second rotating member 520, so that the bearing bracket 400 can rotate relative to the base 500. The second rotating member 520 further includes a stop portion 521 protruding toward the first rotating member 430, and the stop portion 521 is located at an end of the second rotating member 520 in the first direction A. When the first rotating member 430 rotates relative to the second rotating member 520 to the stop portion 521, the first rotating member 430 stops rotating.

In the hinge apparatus 10 shown in FIG. 38, the first shaft sleeve 130 and the first shaft core 200 are in interference fit with each other. Interference fit exists at at least one of the following locations: between the second shaft sleeve 140 and the second shaft core 300, between the first rotating member 430 of the bearing bracket 400 and the second rotating member 520 of the base 500, or between the sliding block 600 and the base 500. This helps improve an overall torque provided by the hinge apparatus 10.

In an implementation, the bearing bracket 400 is detachably connected to the support plates, and the support plates are not shown in FIG. 38.

In an implementation, the two support plates 510 are fastened via a screw, and the two support plates 510 are of a symmetric "F"-shaped structure. Specifically, the support plate 510 includes a first connecting member 517 and a second connecting member 518 that extend in the second direction B. The two first connecting members 517 of the two support plates 510 are fastened via a screw, and the two second connecting members 518 of the two support plates 510 are fastened via a screw. The fourth rotating member 515 is located between the first connecting member 517 and the second connecting member 518 in the first direction A, and the middle of the first shaft sleeve assembly 100 is located below the two second connecting members 518.

In an implementation, the bearing bracket 400 has an accommodation opening 480 that is opened toward the first shaft sleeve assembly 100, the first end 110 (namely, the first shaft sleeve 130) of the first shaft sleeve assembly 100 is located in the accommodation opening 480, and the second shaft core 300 is fastened to a side wall of the accommodation opening 480, so that the second shaft core 300 is fastened to the bearing bracket 400.

The following describes an assembly method and total torque analysis according to the fifth embodiment of this application. Still refer to FIG. 36 to FIG. 38. In an implementation, in a process of assembling the hinge apparatus 10 shown in FIG. 36, the first shaft sleeve 130 is first placed in the accommodation opening 480 of the bearing bracket 400, then, the first shaft core 200 penetrates the first shaft sleeve 130, two ends of the first shaft core 200 are fastened to the bearing bracket 400, the second shaft sleeve 140 is sleeved on the second shaft core 300, and two ends of the second shaft core 300 separately penetrate the sliding block 600. Further, the first rotating member 430 of the bearing bracket 400 slides into the second rotating member 520 of the base, the third rotating member 650 of the sliding block 600 slides into the fourth rotating member 515 of the base 500. Finally, the two first connecting members 517 of the two support plates 510 are fastened via the screw, and the two second connecting members 518 of the two support plates 510 are fastened via the screw. In this way, the hinge apparatus 10 finally presents the structure shown in FIG. 36.

In an implementation, Mₜₒₜₐₗ=k₁×M₁+k₂×M₂+k₃×M₃+k₄×M₄. Herein, Mₜₒₜₐₗ is a total torque in the embodiment shown in FIG. 38, M₁ is generated at a location at which the first shaft core 200 is in interference fit with the first shaft sleeve 130, M₂ is generated at a location at which the second shaft core 300 is in interference fit with the second shaft sleeve 140, M₃ is generated at a location at which the bearing bracket 400 is rotatably connected to the base 500, a torque M₄ is generated at a location at which the sliding block 600 is slidably connected to the base 500, and k₁ to k₄ are contribution coefficients of the locations at which the torques are generated to the total torque. The torques are generated at the foregoing four locations, so that the overall torque Mₜₒₜₐₗ of the hinge apparatus 10 can be increased. In this way, the hinge apparatus 10 can support a larger electronic device or support the electronic device at a large angle. Alternatively, when the supported electronic device is determined, a volume of the hinge apparatus 10 may be reduced, which helps implement a light and thin design of the entire electronic device.

In some implementations, interference fit may be set at some locations to generate torques. For example, Mₜₒₜₐₗ=k₁×M₁+ₖ₂×M₂+k₃×M₃. For example, Mₜₒₜₐₗ=k₁×M₁+k₂×M₂+k₄×M₄.

It should be noted that, in the first embodiment to the fifth embodiment, the possible implementation of the first shaft sleeve 130 and the second shaft sleeve 140, the possible implementation of the second shaft core 300 and the base 500, and the possible implementation of the bearing bracket 400 and the base 500 may be mutually referenced based on a requirement, and are not limited to the specific implementations in the first embodiment and the fifth embodiment.

The hinge apparatus, the electronic device, and the housing provided in embodiments of this application are described in detail above. The principle and embodiments of this specification are described herein with specific examples. The descriptions about the foregoing embodiments are merely provided to help understand the method and core ideas of this application. In addition, a person of ordinary skill in the art can make modifications to specific embodiments and application scopes according to the ideas of this application. Therefore, in conclusion, the content of this specification shall not be construed as a limitation on this application.

## Claims

1. A hinge apparatus having an open state and a closed state, wherein the hinge apparatus comprises:
a base;
a bearing bracket, wherein the bearing bracket is rotatably connected to the base, for the bearing bracket to be opened or closed relative to the base;
a first shaft core, fastened to the bearing bracket;
a second shaft core, slidably connected to the base; and
a first shaft sleeve assembly, wherein a first end of the first shaft sleeve assembly is sleeved on the first shaft core and is capable of rotating relative to the first shaft core, a second end of the first shaft sleeve assembly is sleeved on the second shaft core and is capable of rotating relative to the second shaft core, and the two ends of the first shaft sleeve assembly are respectively in interference fit with the first shaft core and the second shaft core, to enable the first shaft sleeve assembly and each of the first shaft core and the second shaft core to be configured to provide a torque for the hinge apparatus in a process in which the hinge apparatus switches between the open state and the closed state.

2. The hinge apparatus according to claim 1, wherein a rotation center at which the bearing bracket rotates around the base is denoted as a virtual central axis, and the first shaft core and the second shaft core are parallel to the virtual central axis; and
in a first direction, the first shaft core is located between the second shaft core and the virtual central axis, or the second shaft core is located between the first shaft core and the virtual central axis, and the first direction is perpendicular to the virtual central axis and parallel to a surface that is of the base and that faces the bearing bracket; or
in the first direction, the virtual central axis is located between the first shaft core and the second shaft core; or
the first shaft core coincides with the virtual central axis in the first direction, and the second shaft core and the virtual central axis are spaced apart in the first direction.

3. The hinge apparatus according to claim 1 or 2, wherein the first shaft sleeve assembly comprises a first shaft sleeve and a second shaft sleeve that are fastened to each other, the first shaft sleeve is sleeved on the first shaft core, is capable of rotating relative to the first shaft core, and is in interference fit with the first shaft core, and the second shaft sleeve is sleeved on the second shaft core, is capable of rotating relative to the second shaft core, and is in interference fit with the second shaft core.

4. The hinge apparatus according to claim 3, wherein the first shaft sleeve is provided with a first opening that penetrates an inner surface and an outer surface of the first shaft sleeve, and the first opening extends in an axial direction of the first shaft sleeve; and/or
the second shaft sleeve is provided with a second opening that penetrates an inner surface and an outer surface of the second shaft sleeve, and the second opening extends in an axial direction of the second shaft sleeve.

5. The hinge apparatus according to claim 4, wherein a first shaft sleeve plane part is provided on the inner surface of the first shaft sleeve, a first shaft core plane part parallel to the shaft sleeve plane part is provided on an outer surface of the first shaft core, and in the closed state, the first shaft sleeve plane part and the first shaft core plane part are disposed opposite to each other; and/or
the first shaft sleeve plane part is provided on the inner surface of the first shaft sleeve, an open-lock plane part is further provided on the outer surface of the first shaft core, in the closed state, the first shaft sleeve plane part is spaced from the open-lock plane part, and in the open state, the first shaft sleeve plane part and the open-lock plane part are disposed opposite to each other.

6. The hinge apparatus according to any one of claims 1 to 5, wherein the second shaft core is in interference fit with the base, to generate a torque in a process in which the second shaft core and the base slide relative to each other.

7. The hinge apparatus according to any one of claims 1 to 5, wherein the second shaft core slides relative to the base in the first direction, and the first direction intersects an axis of the second shaft core; or
a direction in which the second shaft core slides relative to the base has a component in the first direction and the second shaft core slides in a straight line; or
the second shaft core slides relative to the base in an arc direction, wherein the arc direction has a component in the first direction.

8. The hinge apparatus according to any one of claims 1 to 5, wherein the hinge apparatus further comprises two sliding blocks, the two sliding blocks are respectively fastened to two ends of the second shaft core in a second direction, the base comprises two support plates that are arranged in the second direction and are spaced apart, and the two sliding blocks and the second shaft core are located between the two support plates in the second direction; and the sliding block and the support plate that are disposed on a same side in the second direction are slidably connected and are capable of sliding relative to each other, and the second direction is parallel to an axis of the second shaft core.

9. The hinge apparatus according to claim 8, wherein in the sliding block and the support plate that are disposed on the same side in the second direction, a protrusion is provided on a side that is of the support plate and that faces the sliding block in the second direction, a groove is provided on a side that is of the sliding block and that faces the support plate, and the protrusion is located in the groove and is capable of sliding relative to the groove.

10. The hinge apparatus according to any one of claims 1 to 5, wherein the hinge apparatus further comprises a sliding plate and a shaft core fastener that are fastened to each other, the base comprises two support plates that are arranged in a second direction and are spaced apart, the second direction is parallel to an axis of the second shaft core, a groove is provided on an inner side wall of each support plate, two ends of the sliding plate in the second direction are located in the grooves and are capable of sliding relative to the grooves, a part of the second shaft core is fastened to the shaft core fastener, and a part of the second shaft core is rotatably connected to the second end of the first shaft sleeve assembly.

11. The hinge apparatus according to any one of claims 1 to 5, wherein the hinge apparatus further comprises one sliding block, the sliding block is provided with a through hole that penetrates the sliding block in a second direction, the second shaft core penetrates the through hole and is fastened to the sliding block, two ends of the second shaft core penetrate the through hole, and the second end of the first shaft sleeve assembly is sleeved on at least one end of the second shaft core and is capable of rotating relative to the second shaft core; and
the base comprises a support plate that extends in the first direction, the sliding block has a slide groove whose opening faces the support plate, the support plate penetrates the slide groove in the first direction, and the sliding block is capable of sliding relative to the support plate, wherein the first direction intersects the second direction, and the second direction is parallel to an axis of the second shaft core.

12. The hinge apparatus according to any one of claims 1 to 11, wherein the bearing bracket and the base are in interference fit with each other, to generate a torque in a process in which the bearing bracket and the base rotate relative to each other.

13. The hinge apparatus according to any one of claims 1 to 12, wherein the hinge apparatus further comprises a first rotating member and a second rotating member, the first rotating member is fastened to the bearing bracket, the second rotating member is fastened to the base, and the bearing bracket is rotatably connected to the base through fit between the first rotating member and the second rotating member.

14. The hinge apparatus according to claim 13, wherein the second rotating member comprises two arc-shaped sliding grooves, curvature centers of the two sliding grooves are provided on a same side and are away from a bottom of the base, the first rotating member comprises two arc-shaped slide protrusions, and the two slide protrusions are respectively located in the two sliding grooves and are capable of sliding relative to the sliding grooves.

15. The hinge apparatus according to claim 13, wherein the first rotating member comprises a first guide rail block and a second guide rail block, the first guide rail block comprises an accommodation groove whose opening is away from the bottom of the base, the second guide rail block is located in the accommodation groove and is capable of rotating relative to the first guide rail block, the first guide rail block is rotatably connected to the base, and the second guide rail block is fastened to the bearing bracket.

16. The hinge apparatus according to any one of claims 1 to 15, wherein the hinge apparatus further comprises a second shaft sleeve assembly, a third shaft core, and a fourth shaft core, the first shaft sleeve assembly and the second shaft sleeve assembly are located on two sides of the rotation center at which the bearing bracket rotates around the base, the third shaft core is fastened to the bearing bracket, the fourth shaft core is slidably connected to the base, a first end of the second shaft sleeve assembly is sleeved on the third shaft core and is capable of rotating relative to the third shaft core, a second end of the second shaft sleeve assembly is sleeved on the fourth shaft core and is capable of rotating relative to the fourth shaft core, and the two ends of the second shaft sleeve assembly are respectively in interference fit with the third shaft core and the fourth shaft core, to enable the second shaft sleeve assembly and each of the third shaft core and the fourth shaft core to be configured to provide a torque for the hinge apparatus in a process in which the hinge apparatus switches between the open state and the closed state.

17. A hinge apparatus having an open state and a closed state, wherein the hinge apparatus comprises:
a base;
a bearing bracket, wherein the bearing bracket is rotatably connected to the base, for the bearing bracket to be opened or closed relative to the base;
a first shaft core, fastened to the bearing bracket;
a second shaft core, slidably connected to the base; and
a first shaft sleeve assembly, wherein a first end of the first shaft sleeve assembly is sleeved on the first shaft core and is capable of rotating relative to the first shaft core, and a second end of the first shaft sleeve assembly is sleeved on the second shaft core and is capable of rotating relative to the second shaft core, wherein
the first end of the first shaft sleeve assembly is in interference fit with the first shaft core, and interference fit exists at at least one of the following locations: between the second end of the first shaft sleeve assembly and the second shaft core, between the second shaft core and the base, or between the bearing bracket and the base, to provide a torque for the hinge apparatus at a location of the interference fit in a process in which the hinge apparatus switches between the open state and the closed state.

18. An electronic device, comprising a device body, a support member, and the hinge apparatus according to any one of claims 1 to 17, wherein the hinge apparatus is located between the device body and the support member, the bearing bracket in the hinge apparatus is fastened to the support member, and the base in the hinge apparatus is fastened to the device body; and
when the hinge apparatus is in the open state, the support member is open relative to the device body via the hinge apparatus, and the support member is configured to support the device body.

19. A housing, wherein the housing comprises a housing body, a support member, and the hinge apparatus according to any one of claims 1 to 17, the hinge apparatus is located between the housing body and the support member, the bearing bracket in the hinge apparatus is fastened to the support member, and the base in the hinge apparatus is fastened to the housing body; and
when the hinge apparatus is in the open state, the support member is open relative to the housing body via the hinge apparatus.
